(19) Europäisches Patentamt
European Patent Office
Office européen des brevets

(11) **EP 3 387 387 B1**

(12) **EUROPÄISCHE PATENTSCHRIFT**

(45) Veröffentlichungstag und Bekanntmachung des Hinweises auf die Patenterteilung:
**23.10.2019  Patentblatt 2019/43**

(21) Anmeldenummer: **16828919.7**

(22) Anmeldetag: **07.12.2016**

(51) Int Cl.:
**G01P 3/488** (2006.01)     **G01D 5/16** (2006.01)
**G01D 5/20** (2006.01)      **G01P 13/04** (2006.01)
**G01D 3/02** (2006.01)      **G01D 5/14** (2006.01)
**G01P 3/487** (2006.01)     **G01D 5/244** (2006.01)
**G01R 33/09** (2006.01)

(86) Internationale Anmeldenummer:
**PCT/DE2016/000433**

(87) Internationale Veröffentlichungsnummer:
**WO 2017/097284 (15.06.2017 Gazette 2017/24)**

(54) **MAGNETISCHER UMDREHUNGSZÄHLER ZUR SELBSTERKENNUNG VON FEHLERZUSTÄNDEN BEI DER BESTIMMUNG VON MIT DIESEM UMDREHUNGSZÄHLER ERMITTELBAREN UMDREHUNGSZAHLEN**

MAGNETIC REVOLUTION COUNTER FOR SELF-DETECTING ERROR STATES WHEN DETERMINING NUMBERS OF REVOLUTIONS WHICH CAN BE DETERMINED BY SAID REVOLUTION COUNTER

COMPTE-TOURS MAGNÉTIQUE POUR LA DÉTECTION AUTOMATIQUE D'ÉTATS D'ERREUR LORS DE LA DÉTERMINATION DE NOMBRES DE TOURS DÉTERMINABLES AVEC CE COMPTE-TOURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.12.2015  DE 102015016164**

(43) Veröffentlichungstag der Anmeldung:
**17.10.2018  Patentblatt 2018/42**

(73) Patentinhaber:
• **Leibniz-Institut für Photonische Technologien e.V.**
**07745 Jena (DE)**
• **Horst Siedle GmbH & Co. KG.**
**78120 Furtwangen (DE)**

(72) Erfinder:
• **DIEGEL, Marco**
**07743 Jena (DE)**
• **DINGLER, Peter**
**73432 Aalen (DE)**
• **MATTHEIS, Roland**
**07743 Jena (DE)**
• **SCHERZINGER, Manfred**
**73760 Ostfildern (DE)**

(74) Vertreter: **Pfeiffer, Rolf-Gerd**
**Patentanwaltsbüro**
**Pfeiffer & Kollegen**
**Engelplatz 11**
**07743 Jena (DE)**

(56) Entgegenhaltungen:
DE-A1-102004 020 149     DE-A1-102010 010 893
DE-A1-102011 075 306     DE-A1-102015 103 456

**Beschreibung**

Die Erfindung betrifft einen magnetischen Umdrehungszähler zur Selbsterkennung von Fehlerzuständen in diesen Umdrehungszählern und zur Bestimmung von mit diesem Umdrehungszähler ermittelbaren Umdrehungszahlen eines äußeren Magnetfeldes, welche in vielfältigen Gebieten der Technik, insbesondere im Automobil- und Getriebebau vorteilhaft Anwendung finden können, da solche Umdrehungszähler miniaturisiert ausgebildet und stromlos betrieben werden können.

Grundsätzlich sind Umdrehungszähler zur berührungslosen und leistungslosen Zählung von Umdrehungen unter Nutzung von magnetischen Domänenwänden (DW) an sich bekannt und beispielsweise in DE 10 2008 063 226 A1, DE 10 2010 022 611 A1, DE 10 2011 075 306 A1 und DE 10 2013 018 680 A1 eingehend beschrieben.

Den in vorstehenden Schriften offenbarten Umdrehungszähler ist gemeinsam:
Die zum Einsatz gelangenden Sensorsysteme bestehen aus mindestens einem Sensorelement und mindestens einem äußeren Magnetfeld, wobei berührungsfrei entweder das Sensorelement am Magnetfeld, bzw. das Magnetfeld am Sensorelement vorbeibewegt oder gedreht wird.

Das Sensorelement weist zumindest partiell einen Schichtaufbau bestehend aus mindestens einer hartmagnetischen und mindestens einer weichmagnetischen Schicht, getrennt von einer unmagnetischen Schicht, auf. Im Betrieb des Sensorsystems kann das Drehen oder Vorbeibewegen des Magnetfeldes am Sensorelement (oder umgekehrt) nur die Magnetisierung der weichmagnetischen Schicht und nicht die Magnetisierung der hartmagnetischen Schicht ändern. Hierdurch wird die Magnetisierung der weichmagnetischen Schicht im Sensorelement ganz oder teilweise eher parallel oder eher antiparallel zur Magnetisierung der hartmagnetischen Schicht orientiert sein. Diese unterschiedliche Ausrichtung der Magnetisierungen führt zu einem Unterschied des elektrischen Widerstands in unterschiedlichen Leitbahnabschnitten, der mittels GMR- oder TMR-Effekt auslesbar ist.

Innerhalb der weichmagnetischen Schicht sind zwei verschieden magnetisierte Bereiche durch eine magnetische Domänenwand (DW) voneinander getrennt.

Im Betrieb des Sensorsystems führt eine Lageveränderung des äußeren Magnetfelds, bspw. durch Rotation, im Sensorelement zur leistungslosen Bewegung der im Sensorelement existierenden magnetischen Domänenwände.

Die ausgelesenen DW-Positionen sind eineindeutig bestimmten, mit dem konkreten Umdrehungszähler ermittelbaren Umdrehungen (Umdrehungszahlen) zugeordnet und werden in einer Auswerteelektronik ermittelt. In bevorzugten Ausführungsformen sind mehrere Sensorelemente oder mehrere Teile eines Sensorelementes in Wheatstone-Brücken oder Wheatstone-Halbbrücken elektrisch miteinander verschaltet, wodurch der Einfluss der Temperatur auf das magnetoresistive Signal unterdrückt wird.

Die Umdrehungszähler nach der DE 10 2008 063 226 A1 sind geometrisch durch eine rautenförmige Spirale gebildet, die an einem Ende in einer großen Fläche endet. Diese große, bevorzugt kreisförmige Fläche fungiert als Domänenwandgenerator (DWG) und ist aus demselben Material wie die Spirale gebildet. Nach jeder 180° Magnetfelddrehung oder 180° Sensorelementdrehung wird in diesem Domänenwandgenerator eine sogenannte 180°-Domänenwand am Übergang Fläche-Spirale erzeugt. Diese 180°-DW wandert in die Spirale hinein. Die erzeugten 180°-DW werden bei Drehrichtung des Magnetfeldes im Spiralendrehsinn zum Spiralende transportiert, bzw. bei Drehrichtung entgegen des Spiralendrehsinns werden die Domänenwände zum DWG hin transportiert. Dabei annihiliert die aus der Spirale zuerst am DWG ankommende 180°-DW mit der zugleich im DWG erzeugten 180°-DW. Die Spirale kann durch sukzessives Drehen des Magnetfeldes somit schrittweise von Domänenwänden gelöscht werden. Äquivalent zur Drehung des Magnetfeldes am ortsfesten Sensorelement ist die Drehung des Sensorelementes zum ortsfest montierten Magnetsystem.

Umdrehungszähler nach der DE 10 2011 075 306 A1 bestehen aus zwei rautenförmigen Spiralen mit je einem DWG an einem Ende mit gegen gerichteten Drehsinn, bzw. aus einer Kombination dieser zwei Spiralen mit nur einem DWG an einem Ende oder in der Mitte.

Gemeinsam ist diesen Umdrehungszählern nach der DE 10 2008 063 226 A1 und DE 10 2011 075 306 A1, dass sich bei jeder halben Umdrehung die Anzahl der 180°- Domänenwände in jeder Spirale um 1 ändert.

Dies ist anders bei den Umdrehungszählern, die mindestens eine geschlossene Schleife mit mindestens einer Kreuzung (DE 10 2013 018 680 A1) oder mindestens eine geschlossene Schleife mit mindestens einer Brücke (DE 10 2010 022 611 A1) aufweisen. Bei diesen Umdrehungszählern wurden die beiden Enden einer Spirale zu einer geschlossenen Schleife miteinander verbunden. Bei n Windungen kreuzt die direkte Verbindung (n-1) Windungen. Eine zweiwindige Spirale wird somit zu einer Schleife mit einer Kreuzung und eine dreiwindige Spirale zu einer Schleife mit zwei Kreuzungen. Jede Windung kann maximal zwei Domänenwände aufnehmen, so dass bei einer Schleife mit n Windungen maximal 2n Domänenwände existieren können.

In einer geschlossenen Schleife wird im regulären Zähl-Betrieb keine DW erzeugt oder vernichtet. Eine Vernichtung oder Erzeugung von Domänenwänden würde zu einem Zählfehler führen und muss ausgeschlossen sein. Umdrehungszähler mit mindestens einer geschlossenen Schleife erfordern, dass in einem Initialisierungsprozess eine genaue Anzahl an Domänenwänden in das Sensorelement geschrieben wird.

Manche Ausführungsformen von Umdrehungszählern mit offenen Spiralen mit DWG können mechanisch initialisiert werden. Dies geschieht z.B. bei einer Spirale mit n Windungen durch Bewegung des Sensorelementes bzw. des äußeren Magneten des Sensorsystems um mindestens n Umdrehungen, um die Spirale komplett mit Domänenwänden zu füllen. Anschließendes Drehen in Gegenrichtung um n Umdrehungen leert die Spirale von Domänenwänden. Für Anwendungen, die Umdrehungen nach rechts und links zählen, wird für eine Initialisierung in Mittenposition die Spirale mit n Umdrehungen maximal mit DW gefüllt und danach mit n/2 Umdrehungen mit entgegengesetztem Drehsinn bis auf n/2 DW geleert.

Allen vorstehend beschriebenen Umdrehungszählern ist gemeinsam, dass das Zählen von Umdrehungen leistungslos durch das Transportieren von Domänenwänden in geschlossenen Schleifen, bzw. das Transportieren mit Erzeugung oder Vernichtung von Domänenwänden in offenen Spiralen erfolgt. Leistungslos erfolgt auch die Speicherung der gezählten Umdrehungen durch eineindeutige DW-Positionen und/oder DW-Anzahlen im Sensorelement.

Leistung wird hingegen benötigt zum Auslesen des Sensorelementes. In bevorzugten Ausführungsformen wird hierzu der Giant Magneto Resistance- (GMR-) oder der Tunnel Magneto Resistance- (TMR-) Effekt genutzt, wobei mehrere Sensorelemente oder Teile eines Sensorelementes gemäß des bekannten Standes der Technik in Wheatstone-Halbbrücken oder Wheatstone-Brücken verschaltet sind.

Je nach Magnetisierung weist ein Sensorelement in unterschiedlichen Abschnitten unterschiedliche elektrische Widerstände, bzw. unterschiedliche Potentiale auf, die, wenn das Sensorelement oder ein Teil eines Sensorelementes in Wheatstone-Halbbrücken oder Wheatstone-Brücken verschaltet ist, auslesbar sind. Zum Auslesen des Magnetisierungszustandes wird ein Messstrom durch das Sensorelement (bzw. die Wheatstone-(Halb-)Brücke) geleitet und das Messergebnis mit definierten Schwellenwerten verglichen. Je nachdem, ob ein Schwellenwert unterschritten oder überschritten ist, kann entschieden werden, ob das Messergebnis z.B. dem Zustand "eine DW ist in dieser Halbbrücke vorhanden" entspricht oder nicht.

In Umdrehungszählern nach der DE 10 2008 063 226 A1 wurde erstmals eine Rautenform mit Einzelkontaktierung von halben Windungen in Wheatstone-Halbbrücken eingeführt. Diese besonders vorteilhafte Ausgestaltung mit Quadratform verwendet pro Windung vier Stege im 90°-Winkel zueinander. Jeweils zwei Stege sind mit Viertelkreisen oder viertelkreisartigen Polygonzügen miteinander verbunden. Die Viertelkreise sind mit elektrischen Kontakten bedeckt, die zusätzlich Teile der angrenzenden Stege derart bedecken, dass die nicht kontaktierten Teile aller Stege zwischen den elektrischen Kontakten bevorzugt gleich lang sind. Die vier Stege jeder Windung sind verschaltet in zwei Wheatstone-Halbbrücken. Die Referenzrichtung liegt in der Diagonalen der Raute bzw. des Quadrats und senkrecht zur Linie zwischen dem Vcc-Kontakt und dem gnd-Kontakt. Hierdurch ist für jeden Feldwinkel immer eine eineindeutige Zuordnung zur Umdrehungszahl mit nur einer quadratischen (rautenförmigen) Spirale möglich. Dies erlaubt, wie in der Publikation "IEEE Transactions on Magnetics, Vol. 45, No 10, pp 3792 - 3795, 2009" dargestellt, eine eineindeutige Zuordnung der Magnetisierung mit der gezählten Umdrehung für alle mit dem Sensor zählbaren Umdrehungen.

Diese Geometrie ermöglicht Umdrehungszähler mit ermittelbaren Umdrehungszahl von n >10. Technisch realisiert ist im Sensorsystem "RSM 2800" der Firma Novotechnik eine quadratische Spirale zur Zählung von bis zu 16 Umdrehungen.

Die geometrischen Bereiche, in denen die Domänenwände innerhalb der Spirale oder Schleife die meiste Zeit über lokalisiert sind, werden nachfolgend als Domänenwandlagen (DW-Lagen) bezeichnet. Bei quadrat- oder rautenförmigen Spiralen sind dies die Viertelkreise oder viertelkreisähnlichen Polygonzüge, die jeweils zwei gerade Stege miteinander verbinden. Damit eine DW einen Viertelkreis durchläuft, muss das äußere Magnetfeld um 90° plus einen Hysteresewinkel von typisch 5° bis 20° gedreht werden. Sobald die DW zum Übergang Viertelkreis-Steg transportiert wird und das anliegende Feld die DW depinnt, durchläuft die DW den Steg mit einer Geschwindigkeit von mehreren 100 m/sec in wenigen 100 ns. Innerhalb dieser sehr kurzen Zeit ist die Drehung des Magnetfeldes vernachlässigbar klein.

Pro Windung gibt es bei einer quadratischen Spirale (bzw. einer quadratischen Schleife) vier Viertelkreise und somit vier DW-Lagen, die mit den elektrischen Kontakten von zwei Wheatstone-Halbbrücken bedeckt sind. Über einer DW-Lage liegt der Vcc- Kontakt, über der gegenüberliegenden DW-Lage der gnd-Kontakt und die zwei dazwischen liegenden DW-Lagen sind jeweils mit einem Mittelkontakt bedeckt.

In allen vorstehend beschriebenen Umdrehungszählern nach dem bekannten Stand der Technik haben die mit einem Wheatstone-Halbbrücken-Mittenkontakt kontaktierten DW-Lagen einen Winkelabstand von 180°.

Durch die Wahl der Richtung der Referenzmagnetisierung im GMR-Schichtstapel ist die Wheatstone-Halbbrücke im Mittelpotential, wenn eine DW in der DW-Lage unter dem Mittelkontakt positioniert ist und sie ist im High-Potential oder im Low-Potential, wenn die DW in der DW-Lage unter dem Vcc- oder dem gnd-Kontakt positioniert ist. Für TMR-Schichtstapel kann dies variabler gewählt werden.

Für jede 180° Magnetfelddrehung werden die im Sensorelement gespeicherten Domänenwände im fehlerfreien Betrieb in die benachbarte Wheatstone-Halbbrücke transportiert. Bei den Umdrehungszählern mit konstanter DW-Anzahl verschiebt sich dabei die DW-Anordnung um den Winkelabstand von 180° im Sensorelement und bei der Spirale mit einem DWG ändert sich zusätzlich die Anzahl der Domänenwände in der Spirale um eine DW. Der Nachweis dieser Bewegung erfolgt über die elektrische Auslesung der Wheatstone-Brücken bzw. -Halbbrücken.

Allen diesen Umdrehungszählern gemeinsam ist, dass das Feld H des Magneten des Sensorsystems im Betrieb innerhalb eines "magnetischen Fensters" zwischen $H_{min}$ und $H_{max}$ liegen muss, wobei $H_{min}$ größer als das maximale Depinningfeld $H_{depinn}$ und $H_{max}$ kleiner als das Nukleationsfeld $H_{Nuk}$ des Sensorelementes sein muss:

$$H_{depinn} < H_{min} \leq H \leq H_{max} < H_{Nuk}$$

Das Maximalfeld $H_{max}$ und Minimalfeld $H_{min}$ wird von der Applikation vorgegeben. Allen diesen Umdrehungszählern ist weiterhin gemeinsam, dass die Sensorelemente beim Maximalfeld $H_{max}$ und beim Minimalfeld $H_{min}$ der Applikation geeignet getestet sind bezüglich einer gewissen Fehlerwahrscheinlichkeit von z.B. kleiner $10^{-7}$. Innerhalb dieses magnetischen Fensters werden die Domänenwände sicher transportiert.

Mit Ausnahme der Umdrehungszähler nach der DE 10 2011 075 306 A1 ist allen oben beschriebenen Umdrehungszählern nach dem Stand der Technik gemeinsam, dass keine Erkennung von Fehlerzuständen vorgesehen und in keiner Ausführungsform implementiert ist.

Umdrehungszähler nach der DE 10 2011 075 306 A1 verwenden eine Anordnung von zwei (rautenförmigen) Spiralen mit entgegen gesetztem Drehsinn, um Fehlerzustände durch gelöschte Domänenwände oder nukleierte Domänenwände zu erkennen. Die beiden Spiralen besitzen entweder je einen Domänenwandgenerator (DWG) oder einen gemeinsamen DWG in der Mitte. Im regulären Zählbetrieb wird somit pro 180° Felddrehung eine DW in eine Spirale injiziert und vom DWG weg transportiert, sowie zugleich in der anderen Spirale eine zum DWG transportierte DW durch Annihilation mit einer vom DWG injizierten DW gelöscht. In den mechanisch blockierten Endpositionen ist somit in einer Endposition z.B. die Spirale mit ccw-Drehsinn komplett mit Domänenwänden gefüllt und die Spirale mit cw-Drehsinn DW-frei sowie in der anderen Endposition ist die Spirale mit ccw-Drehsinn DW-frei und die Spirale mit cw-Drehsinn komplett mit Domänenwänden gefüllt. Die Gesamtzahl der Domänenwände in beiden Spiralen bleibt bei diesen Umdrehungszählern gleich. Dies ermöglicht es zu erkennen, wenn in einer Spirale Domänenwände nukleieren oder annihilieren, da sich hierdurch die Gesamtzahl an Domänenwände ändert gegenüber der DW-Anzahl, die im regulären Zählbetrieb vorgesehen ist. Dadurch, dass im regulären Zählbetrieb die DW-Anzahl nur in der Summe konstant bleibt, aber nicht in jeder einzelnen Spirale, ist es im Fehlerzustand nicht möglich zu detektieren in welcher Spirale der Fehler aufgetreten ist. Es ist mit dieser Lösung somit auch nicht möglich, im Fehlerzustand die Umdrehungszahl zu ermitteln.

Die Erkennung von Fehlmessungen und/oder Fehlfunktionen von Sensoren sowie die redundante Ermittlung von Messwerten ist vor allem im Automobilbereich eine häufige Forderung und Gegenstand diverser Vorschriften und Normen (z.B. ASIL C).

Bei den magnetischen Umdrehungszählern gibt es folgende Fehlerzustände:

a. Elektrischer Fehlerzustand, aufgrund eines Kurzschlusses innerhalb der Wheatstone-(Halb-)brücke oder der Unterbrechung einer Leiterbahn oder eines Sensorsteges;
b. Magnetischer Fehlerzustand aufgrund der Reduzierung (DW-Annihilation) oder Erhöhung (DW-Nukleation) der DW-Anzahl oder der (partiellen) "Nicht-Bewegung" (DW-Pinning) von einer DW im Sensorelement;

Elektrische Fehlerzustände durch Kurzschluss oder Leiterbahn-Unterbrechung oder Sensorsteg-Unterbrechung bewirken Signalpegel, die nicht den zulässigen Signalpegeln High-, Medium- oder Low-Pegel der Wheatstone-(Halb-)brücken entsprechen. Ein elektrischer Fehlerzustand verhindert dauerhaft die Detektion der gezählten Umdrehungen.

Beim Fehlerzustand "DW-Pinning" wird während einer Umdrehungszählung mindestens eine DW für mindestens eine halbe Umdrehung nicht transportiert, wodurch sich der Winkelabstand zu anderen, regulär transportierten Domänenwänden ändert. Beim Fehlerzustand "DW-Annihilation" wird eine DW an eine gepinnte DW heran transportiert, so dass sich diese zwei Domänenwände auslöschen. Beim Fehlerzustand "DW-Nukleation" werden zwei Domänenwände mit einem Winkelabstand von 180° zueinander im Sensorelement erzeugt oder es werden Vielfache von je zwei Domänenwänden erzeugt. Die "magnetischen" Fehlerzustände verhindern in der Regel die korrekte Detektion der Umdrehungszahl, d.h. sie führen zu Fehlmessungen.

Aufgabe der vorliegenden Erfindung ist es, Umdrehungszähler zu schaffen, die bereits im laufenden Betrieb, ohne den Vergleich mit externen Drittmitteln, Fehlmessungen der Umdrehungszahl erkennen und in bevorzugten Ausgestaltungen den Weiterbetrieb des Umdrehungszählers ohne Neuinitialisierung ermöglichen.

Die Aufgabe wird durch die Merkmale von Anspruch 1 gelöst, vorteilhafte Ausgestaltungen sind Gegenstand der nachgeordneten Patentansprüche.

Das Wesen der Erfindung besteht darin, dass zunächst ein magnetischer Umdrehungszähler zur Bestimmung einer vorgebbaren Anzahl zu bestimmender Umdrehungen eines äußeren Magnetfelds, erzeugt durch ein rotierendes Element, respektive ein Polrad, respektive einen linearen magnetischen Maßstab vorgesehen ist,

- der magnetische Domänenwandleitbahnen beinhaltet, die aus offenen Spiralen oder in sich geschlossenen mehrfach verwundenen Schleifen bestehen, die durch einen GMR-Schichtstapel oder einer weichmagnetischen Schicht mit lokal vorhandenen TMR-Schichtstapeln gebildet sind und

- in die magnetische 180°-Domänenwände einbringbar und -durch Messung des elektrischen Widerstands vorgebbarer Spiralen- oder Schleifenabschnitte- tlw. entsprechend des bekannten Standes der Technik lokalisierbar sind,

- wobei erfindungsgemäß hier jedoch in die Domänenwandleitbahnen eine oder mindestens zwei magnetische Domänenwände, bzw. in bevorzugten Ausführungsformen vier magnetische Domänenwände, durch Mittel zum Erzeugen, Pinnen oder definierten Löschen von Domänenwänden eingebracht sind, und

- auf den Domänenwandleitbahnen elektrische Kontakte derart vorgesehen sind, dass die Domänenwandleitbahnen diagonal gegenüber liegend von je einem Vcc- und einem gnd-Kontakt gemeinsam oder in Gruppen von mehreren Vcc- und gnd-Kontakten für Multiplex-Auslesung erfasst sind und

- bezogen auf die über dem Vcc- und gnd-Kontakt(en) liegende Diagonale entweder beidseitig oder in bevorzugten erfindungsgemäßen Ausführungsformen ausschließlich einseitig elektrische Kontakte vorgesehen sind, die

- im Wesentlichen mittig zwischen genanntem Vcc- und gnd-Kontakt(en) jeweils eine Windung oder bei Multiplex-Auslesung mehrere Windungen auf jedem dazwischen liegenden Domänenwandleitbahnabschnitt kontaktieren und

- genannte Kontakte zu separaten, vorzugsweise parallel auslesbaren oder bei Multiplex-Auslesung zu rasch hintereinander, quasi gleichzeitig auslesbaren Wheatstonehalbbrücken verschaltet sind,

- wobei die von den Wheatstonehalbbrücken ermittelten Widerstandsverhältnisse als Signalpegel sämtlich in einem Speicher tabellenartig abgelegt sind, der zur Ermittlung der aktuellen Umdrehungszahl fortlaufend mit in einem weiteren Speicher abgelegten, der konkreten Umdrehungszahl entsprechenden, tabellenartigen Sollwertmuster verglichen wird, und

- wenn keine Übereinstimmung zwischen einem Sollwertmuster und den von den Wheatstonehalbbrücken ermittelten Widerstandsverhältnissen existiert, diese mit in einem weiteren Speicher abgelegten, der konkreten Umdrehungszahl und einem bestimmten Fehler entsprechenden, tabellenartigen Fehler-Sollwertmuster verglichen wird und

- als eineindeutiger Umdrehungs- oder Verschiebungswert oder sofort als nicht korrigierbarer Fehler ausgebbar ist.

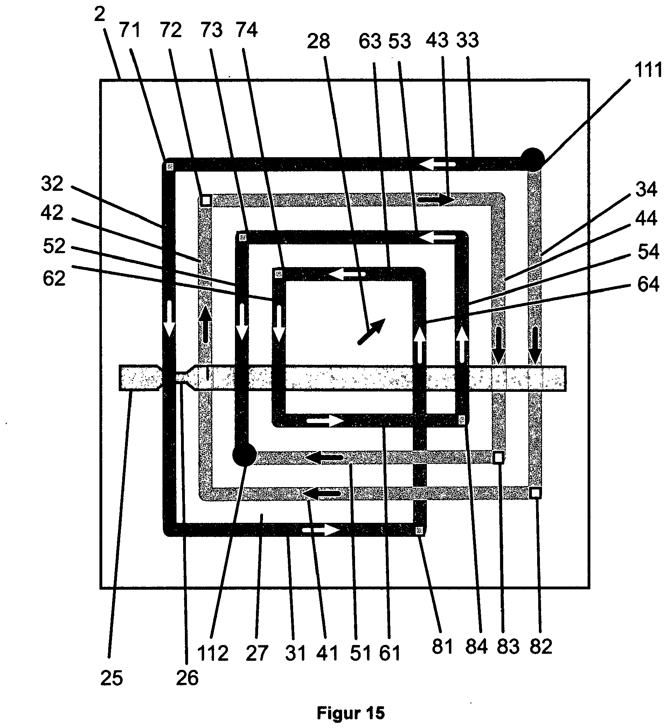

Alternativ zur Auslesung des Sensorelementes mit Potentialmessungen durch eine Verschaltung in Wheatstonehalbbrücken sieht die Erfindung auch vor, das Sensorelement durch Messung der (TMR-)Widerstände aller Windungen auszulesen. Hierzu wird entweder jede einzelne Windung mit je einem gnd-Kontakt und je einem Vcc-Kontakt kontaktiert oder in bevorzugten Ausführungsformen mit Multiplex-Auslesung mit einem gemeinsamen gnd-Kontakt und je einem Vcc-Kontakt auf je einer Windung, bzw. mit einem gemeinsamen Vcc-Kontakt und je einem gnd-Kontakt auf je einer Windung, kontaktiert. Die gnd- und Vcc-Kontakte sind bevorzugt diagonal gegenüber liegend angeordnet. Figur15 zeigt eine Ausführungsform für diese Verschaltung. Die ermittelten Widerstände werden hier, wie bei der Verschaltung mit Wheatstonehalbbrücken, als Signalpegel sämtlich in einem Speicher tabellenartig abgelegt, der zur Ermittlung der aktuellen Umdrehungszahl fortlaufend mit in einem weiteren Speicher abgelegten, der konkreten Umdrehungszahl entsprechenden, tabellenartigen Sollwertmuster verglichen wird.

Bevorzugte Ausführungsformen beinhalten, entsprechend des Standes der Technik, einen Drehwinkelsensor oder einen Quadrantensensor, um durch Vorauswahl eines Feldwinkelquadranten die Messwerte nur mit denjenigen Sollwertmustern zu vergleichen, die mit dem gemessenen Feldwinkelquadranten verknüpft sind. Dies reduziert die Anzahl der maximal erforderlichen Vergleiche auf ein Viertel und beschleunigt somit die Umdrehungszahl-Bestimmung.

Die Anzahl der maximal erforderlichen Vergleiche zur Umdrehungszahl-Bestimmung wird weiterhin dadurch gering gehalten, dass im regulären Zählbetrieb die DW-Anzahl konstant bleibt, wodurch pro Umdrehung und Feldwinkelquadranten nur genau je ein mögliches Signalmuster existiert und somit auch nur je ein Sollwertmuster zum Vergleich abgespeichert sein muss.

Gemäß vorliegender Erfindung sind dabei die, die Domänenwandleitbahnen bildenden offenen Spiralen oder in sich geschlossenen, mehrfach verwundenen Schleifen im Wesentlichen rhombusförmig ausgebildet, wobei die genannten Kontakte die Eckbereiche der Rhomben erfassen. Weiterhin ist die definierte Beabstandung bei Einsatz zweier benachbarter Domänenwände erfindungsgemäß bevorzugt zu 540° festgelegt.

Anstelle der Verwendung von GMR-Schichtstapeln ist es auch erfindungsgemäß möglich, die Domänenwandleitbahnen aus einem weichmagnetischen Material - z.B. Permalloy - herzustellen und die Vcc- und gnd-Kontakte auf TMR-Schichtstapel zu plazieren, die auf den Domänenwandleitbahnen, z.B. in der Mitte, vorgesehen sind. Die elektrischen Mittelkontakte dagegen kontaktieren die weichmagnetische Domänenwandleitbahn auch hier direkt in den Eckbereichen der genannten Rhomben.

Das Wesen zur Bestimmung der Umdrehungszahlen besteht darin, dass die Bestimmung der gezählten Umdrehung mittels einer Auswerteelektronik erfolgt, die in einem ersten Schritt einen Vergleich der Signale aller ausgelesenen Wheatstone-Halbbrücken (oder der Widerstände aller Windungen bei Widerstandsmessung) durchführt und mit einer abgespeicherten Tabelle, in der für jede zählbare Umdrehung die jeweiligen Signale der Wheatstone-Halbbrücken (bzw. der Widerstände aller Windungen) hinterlegt sind, durchführt. Das heißt, die Auswerteelektronik gibt als gezählte Umdrehung diejenige aus, bei der das Muster aus den gemessenen Signalspannungen von Windung 1 bis Windung n der offenen Spiralen oder in sich geschlossenen mehrfach verwundenen Schleifen mit einem abgespeicherten Signalmuster für Windung 1 bis Windung n übereinstimmt. Wenn keine Übereinstimmung gefunden wurde, erfolgt in einem zweiten Schritt der Vergleich der gemessen Signale aller ausgelesenen Wheatstone-Halbbrücken (oder der Widerstände aller Windungen bei Widerstandsmessung) mit einer weiterhin abgespeicherten Tabelle, in der für jede zählbare Umdrehung und für jeden möglichen Fehlerzustand die jeweiligen Signale der Wheatstone-Halbbrücken (bzw. der Widerstände aller Windungen) in einem weiteren Speicher hinterlegt sind.

Aufgrund der 90°-Winkel in den bevorzugten Ausführungsformen mit einer quadratischen Spirale oder in sich geschlossenen quadratischen Schleife ändert sich das Potential nach jeweils 90° Felddrehung, so dass zumindest für jeden 90°-Feldwinkelbereich (Feldwinkel-Quadranten) ein entsprechendes Sollwertmuster abgespeichert ist, das mit dem Messwert vom Winkelsensor (respektive Quadrantensensor) zum Vergleich mit dem Umdrehungszähler-Signalen ausgewählt wird. Entsprechend werden für jeden Feldwinkel-Quadranten zusätzlich Fehler-Sollwertmuster zum Vergleich vorgehalten.

Die in die Schleifen oder Spiralen eingeprägten Magnetisierungsmuster ermöglichen somit eine eineindeutige Bestimmung der gezählten Umdrehungen selbst bei einer zulässigen Hysterese von $\pm 45°$. Aus Gründen der Betriebssicherheit wird man immer Feldstärken (z.B. 120% von $H_{min}$) wählen, bei der die reale Hysterese immer deutlich kleiner als $\pm 30°$ ist.

Sämtliche Ausgestaltungen des erfindungsgemäßen Umdrehungszählers besitzen für jede zählbare Umdrehung ein eineindeutiges Magnetisierungsmuster (MM). Jedes Sensorelement mit einem GMR-Schichtstapel ist in Wheatstone-(Halb-)brücken verschaltet und wird durch Potentialmessungen ausgelesen. Sensorelemente mit einem TMR-Schichtstapel können in Wheatstone-(Halb-)Brücken verschaltet sein. Alternativ kann anstelle einer Potentialmessung auch eine Messung der Tunnelkontakt-Widerstände erfolgen, aufgrund des großen TMR-Hubes von >100%. Abweichend vom Stand der Technik liest die Ausleseelektronik erfindungsgemäß immer alle Wheatstone-(Halb-)brücken bzw. Tunnelkontakt-Widerstände quasi zeitgleich aus. Die gemessenen Signalpegel der Wheatstone-(Halb-)brücken werden in definierter Sequenz verarbeitet, z.B. bei einer Spirale mit n Windungen in der Reihenfolge von Windung 1 bis Windung n. Diese Reihenfolge an Signalpegeln wird nachfolgend als Signalpegelfolge (SPF) bezeichnet. Die gemessene SPF wird mit abgespeicherten Sollwert-SPF verglichen, die für jede zählbare Umdrehung von der Ausleseelektronik vorgehalten werden. Diese Sollwert-SPF sind neu gegenüber dem Stand der Technik und ermöglichen erstmals die sichere Detektion von elektrischen und magnetischen Fehlerzuständen. Elektrische Fehlerzustände detektiert die Ausleseelektronik anhand unzulässiger Signalpegel und magnetische Fehlerzustände z.B. in zwei Schritten. Im ersten Schritt erkennt die Ausleseelektronik einen magnetischen Fehlerzustand daran, dass keine Übereinstimmung zwischen gemessener SPF und einer Sollwert-SPF existiert. Im zweiten Schritt detektiert die Ausleseelektronik den Fehlerzustand durch Übereinstimmung der gemessenen SPF mit einer Sollwert-Fehler-SPF, die für jeden denkbaren Zählfehler und für jede zählbare Umdrehung von der Ausleseelektronik in vorteilhaften Ausgestaltungen vorgehalten sind, bzw. von der Ausleseelektronik errechnet werden. Das Vorhalten oder Errechnen von Sollwert-Fehler-SPF ist neu gegenüber dem Stand der Technik. Abhängig vom initialisierten MM gibt die Ausleseelektronik dann in vorteilhaften Ausgestaltungen einen Fehlerwert oder einen Fehlerwert und dennoch die korrekte Umdrehungszahl aus.

Die Detektion der drei möglichen magnetischen Fehlertypen DW-Pinning, DW-Annihilation und DW-Nukleation ist nur möglich, wenn im regulären Zählbetrieb die DW-Anzahl konstant bleibt. Vorteilhafte erfindungsgemäße Ausgestaltungen verwenden Sensorelemente, bei denen die DW-Anzahl nach der Initialisierung im fehlerfreien Zählbetrieb immer unverändert bleibt, d.h. sie haben entweder keinen DW-Generator (DWG) oder zwei komplementär wirkende DW-Generatoren (d.h. vom ersten DWG wird eine DW erzeugt, während zugleich am zweiten DWG eine DW annihiliert wird).

Vorteilhafte erfindungsgemäße Ausgestaltungen verwenden Sensorelemente, bei denen die DW-Anzahl im fehlerfreien Zählbetrieb konstant bleibt, und initialisieren MM mit vier oder mehr Domänenwänden, die immer die Ermittlung der Umdrehungszahl ermöglichen. Diese MM sind in der Auslesung der Anzahl der gezählten Umdrehungen redundant und ebenfalls neu gegenüber dem bekannten Stand der Technik.

Weitere vorteilhafte erfindungsgemäße Ausgestaltungen verwenden Sensorelemente, die topologisch eine redundante Umdrehungszählung ermöglichen.

Kern der erfindungsgemäßen Umdrehungszähler ist die Kombination aus Vorrichtungsbestandteilen - den Sensorelementen mit definierten MM - und den in Speichern vorgehaltenen Sollwert-SPF und Sollwert-Fehler-SPF und dem Vergleich der gemessenen SPF mit den Sollwert-SPF und den Sollwert-Fehler-SPF. Das gegenüber dem Stand der Technik neue Vorhalten von Sollwert-SPF und Sollwert-Fehler-SPF und deren Vergleich mit den tatsächlich ermittelten SPF geschieht in vorteilhaften Ausgestaltungen in einer Ausleseelektronik. Kombiniert man diese nach dem Stand der Technik neuartige Ausleseelektronik mit Sensorelementen nach dem Stand der Technik, so wird auch mit diesen, an sich bekannten Umdrehungszählern erstmals eine Fehlerüberwachung während des Zählbetriebs ermöglicht.

Die vorteilhaften Ausgestaltungen der Erfindung verwenden Magnetisierungsmuster (MM) mit konstanter DW-Anzahl. Ein MM wird definiert durch die initialisierten Positionen von Domänenwänden bzw. von DW-Lücken (DWL) innerhalb einer Kette von Domänenwänden im MM. Damit ein MM zur Ermittlung der Umdrehungszahl geeignet ist, müssen alle MM, die bei der Bewegung durch Magnetfeldänderung entstehen, signifikant unterschiedliche elektrische Signale aufweisen. Ein einfaches Muster mit dieser Eigenschaft entsteht, ausgehend von einem MM, dass ein Sensorelement enthält, das zunächst vollständig mit Domänenwänden besetzt ist, durch Löschung von mindestens zwei benachbarten Domänenwänden. Das heißt, diese zwei DW sind durch zwei DWL ersetzt worden mit einem Winkelabstand von 180° zueinander, wodurch ein Winkelabstand von 540° zwischen den zwei verbleibenden Domänenwänden entsteht, die jeweils an die DWL angrenzen. Im regulären Zählbetrieb wird dieses MM innerhalb des Sensorelementes synchron mit den gezählten Umdrehungen transportiert, wobei die Winkelabstände zwischen je zwei Domänenwänden im MM für die meiste Zeit konstant bleiben. Lediglich beim Transport des MMs kann, bedingt durch die Hysterese der Domänenwandbewegung, das Durchlaufen der DW durch den Steg um wenige Winkelgrade verschieden auftreten.

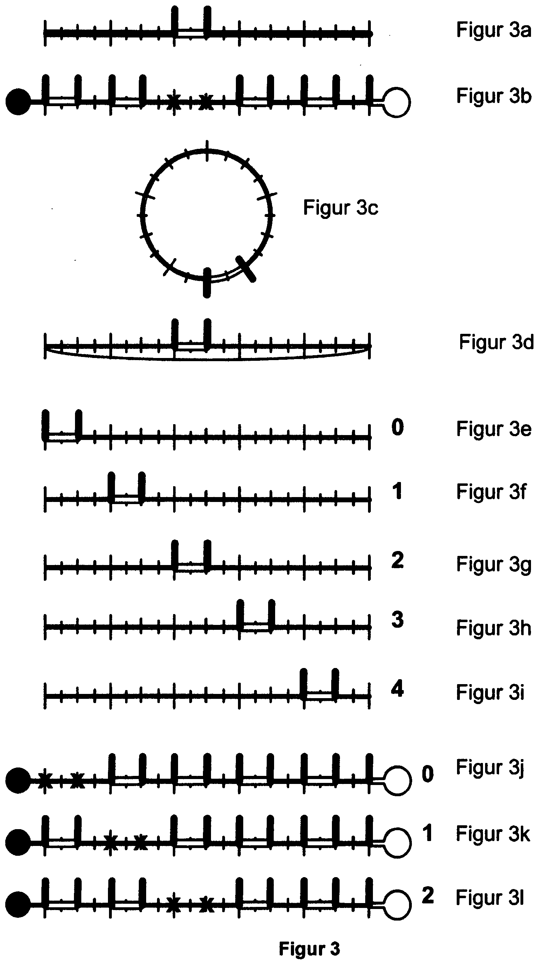

Die Initialisierung der MM kann sowohl in offenen Spiralen nach dem Stand der Technik und geschlossenen Schleifen mit einem strominduzierten Oerstedtfeld erfolgen. Hierbei werden bei der DW-Löschung immer zwei benachbarte Domänenwände unter einer Leiterbahn (25 in Figur 3a) annihiliert oder bei der DW-Erzeugung immer zwei DW unter der Leiterbahn (25 in Figur 3a) nukleiert, die danach sofort auf einen Winkelabstand von 180° auseinander laufen.

Vorteilhafte Ausgestaltungen verwenden Wheatstone-Halbbrücken, die alle immer in definierter Folge ausgelesen werden, z.B. von der äußersten bis zur innersten Windung einer Spirale.

Aufgrund der 90°-Winkel in der vorteilhaften quadratischen Spirale oder Schleife ändert sich das Potential nach jeweils 90° Felddrehung, so dass für jeden 90°-Feldwinkelbereich (Feldwinkel-Quadranten) eine andere Signalpegelfolge (SPF) entsteht.

Ein MM wird repräsentiert durch die Signalpegel der Wheatstone-Halbbrücken mit den DW-Lagen, in denen die Domänenwände lokalisiert sind. Das heißt, innerhalb der Signalpegelfolge (SPF) aller Halbbrücken ist die Signalpegelfolge des MM (SPF-MM) im regulären Zählbetrieb für einen bestimmten Feldwinkel-Quadranten wohl definiert und verschieden von allen anderen SPF, die anderen Feldwinkel-Quadranten entsprechen, da sich die Position des SPF-MM innerhalb der SPF mit der Umdrehungszahl ändert. Anhand der Position des SPF-MM, bzw. anhand der Position einer DW innerhalb des SPF-MM, detektiert die Ausleseelektronik die Umdrehungszahl.

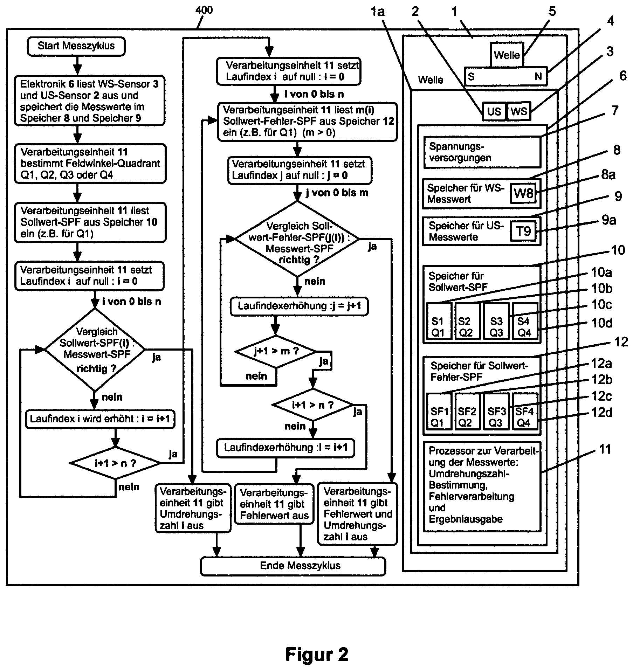

Vorteilhafte Ausgestaltungen bestimmen die Umdrehungszahl, indem die Auswerteelektronik einen Vergleich durchführt zwischen der SPF aller ausgelesenen Wheatstone-Halbbrücken mit einer abgespeicherten Tabelle, die für jede zählbare Umdrehung (unterteilt für jeden Feldwinkel-Quadranten) die jeweiligen Sollwert-SPF der Wheatstone-Halbbrücken hinterlegt hat. D.h. die Auswerteelektronik gibt als Umdrehungszahl diejenige aus, bei der die gemessene SPF von Wheatstone-Halbbrücke 1 (W1) bis Wheatstone-Halbbrücke n (Wn) mit einer abgespeicherten Sollwert-SPF für W1 bis Wn übereinstimmt. Vor dem Vergleich wird der Winkelsensor-Messwert ausgewertet zur Bestimmung des entsprechenden Feldwinkelquadrantens (siehe Figur 2), respektive der Winkel- oder linearen Maßstababschnitte, je nach Ausgestaltung des einwirkenden magnetischen Elements.

Die Ausleseelektronik erkennt anhand des Vergleichs der gemessenen SPF mit den abgespeicherten Sollwerten auch, ob sich die DW-Anzahl gegenüber der Anzahl im initialisierten MM geändert hat oder ob bei gleicher DW-Anzahl sich der Winkelabstand zwischen (mindestens) zwei Domänenwänden geändert hat. Diese Fehler führen nämlich zu SPF, die nicht übereinstimmen mit den Sollwerten. Von der Art des Fehlers, Anzahl der im MM initialisierten Domänenwände und von (zusätzlich) abgespeicherten SPF mit Fehlerzuständen hängt es ab, ob die Ausleseelektronik in diesem Fehlerfall noch eine plausible Umdrehungszahl ausgeben kann oder nicht. Dies wird im Folgenden näher beschrieben.

Zur weiteren Erläuterung des Vorstehenden und der Erfindung sollen nachstehende vorteilhafte, die Erfindung aber nicht beschränkende Ausführungsbeispiele und Figuren dienen.

Es zeigen:

Fig. 1          die wesentlichen Bestandteile eines Umdrehungszählers nach vorliegender Erfindung;

Fig. 2          ein Flussdiagramm für den Ablauf der Bestimmung einer Umdrehung korreliert mit den zugehörigen Baugruppen;

Fig. 3a bis 3l          schematisch drei Sensorelement-Geometrien, die konstante DW-Anzahl ermöglichen mit einem Magnetisierungsmuster (MM) bestehend aus zwei Domänenwänden (Fig.3a, 3c und 3d), bzw. mit einem MM mit zwei DW-Lücken (Fig. 3b). Fig.3e bis 3i, respektive 3i bis 3l, zeigen wie die Umdrehungszählung das MM mit zwei Domänenwänden, respektive zwei DW-Lücken, durch das Sensorelement transportiert. Die dargestellten MM sind ohne Hysterese gezeichnet und befinden sich in keinem Fehlerzustand;

Fig. 4a bis 4k          schematisch MM in einer fünfwindigen, quadratischen Spirale mit zwei Spitzen. Es wird gezeigt, wie sich die Hysterese auf die DW-Positionen innerhalb eines MM's auswirkt (Figur 4a und 4b). Figur 4c und 4d zeigen zwei fehlerfreie MMs und die Figuren 4e bis 4k MM mit beispielhaften Fehlerzuständen. Es wird beschrieben, ob diese MM im Fehlerzustand die Bestimmung der Umdrehungszahl ermöglichen oder nicht;

| Fig. 5 | ein erstes prinzipielles Beispiel für die Ausgestaltung des erforderlichen Sensorelements mit der "180°-Kontaktierung"; |
| Fig. 6 | anhand einer zweiten prinzipiellen Ausgestaltung des erforderlichen Sensorelementes das Einschreiben eines erfindungsgemäß bevorzugt vorgesehenen Magnetisierungsmusters; |
| Fig. 7 | ein drittes prinzipielles Beispiel für die Ausgestaltung eines erforderlichen Sensorelements mit einer erfindungsgemäßen "360°-Kontaktierung"; |
| Fig. 8 | ein viertes prinzipielles Beispiel für die Ausgestaltung des erforderlichen Sensorelements mit einer erfindungsgemäßen Aufteilung in zwei logische Bereiche des Sensorelementes; |
| Fig. 9 | ein fünftes prinzipielles Beispiel für die Ausgestaltung des erforderlichen Sensorelements mit einer erfindungsgemäßen Anordnung von Doppelstegen; |
| Fig. 10a und 10b | schematisch die redundante Umdrehungszahl-Ermittlung in einem Sensorelement mit drei teilerfremden Einzelschleifen im regulären Betrieb und bei Auftreten eines Fehlerzustandes; |
| Fig. 11a bis 11h | schematisch MM in einem vom Stand der Technik bekannten Sensorelement, das mit einer erfindungsgemäßen Ausleseelektronik ausgelesen wird. Es wird gezeigt, welche Maßnahmen erforderlich sind, um Fehlerzustände zu detektieren; |
| Fig. 12 | einen Umdrehungszähler nach Figur 1 kombiniert mit einem Polrad; |
| Fig. 13 | einen Umdrehungszähler nach Figur 1 kombiniert mit einem Linear-Maßstab; |
| Fig. 14a und 14b | beispielhaft eine Ausführung gemäß Fig. 7, hier jedoch mit TMR-Kontakten und einer 360°-Kontaktierung und |
| Fig. 15 | das Sensorelement von Fig 14a mit einer erfindungsgemäßen Anordnung von TMR-Kontakten zur Widerstandsmessung. |

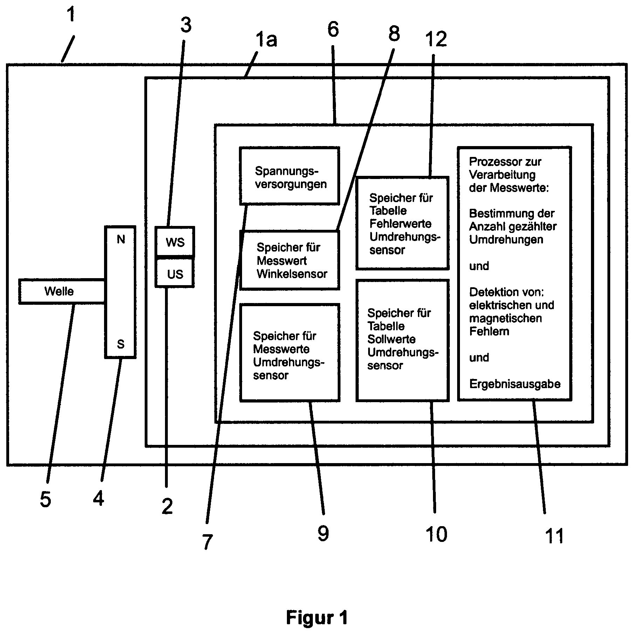

Figur 1 zeigt ein Umdrehungszähler-System 1 mit einem erfindungsgemäßen Umdrehungszähler 1a und einem Magnetsystem 4 mit Nordpol (N) und Südpol (S) montiert an einer drehenden Welle 5. Der Umdrehungszähler 1a besteht aus den Hauptkomponenten: Umdrehungssensor US 2, einem 360°-Winkelsensor WS 3 (respektive Quadrantensensor), und einer Elektronik 6. Die Sensoren 2 und 3 sind ortsfest montiert und detektieren Winkellage und Anzahl der Umdrehungen des rotierenden Magnetfeldes. Die Elektronik 6 beinhaltet Spannungsversorgungen 7 für die Sensoren 2 und 3 und die Verarbeitung der Messwerte, vermittels eines Speichers 8 für den Messwert des Winkelsensors 3, eines Speichers 9 für die Messwerte des Umdrehungssensors 2, eines Speichers 10 für tabellenartig abgespeicherte Sollwerte des Umdrehungssensors 2 und eines Speichers 12 für abgespeicherte Fehlerzustands-Werte und einer Verarbeitungseinheit 11. Diese Verarbeitungseinheit 11 vergleicht die Messwerte aus den Speichern 8 und 9 mit den Tabellenwerten aus dem Speicher 10 und gibt das Ergebnis jeder Messung aus. Wenn der Vergleich der Messwerte aus Speicher 9 mit den Sollwerten aus Speicher 10 keinen gültigen Wert lieferte, werden die abgespeicherten Fehlerwerte aus Speicher 12 mit den Messwerten des Umdrehungszählers aus Speicher 9 verglichen, um neben einem Fehlerwert, in Abhängigkeit vom aufgetretenen Fehler, noch einen plausiblen Wert für die Umdrehungszahl auszugeben.

Figur 2 zeigt schematisch die Bestimmung der Umdrehungszahl und die Fehlerdetektion in einem Ablaufdiagramm 400 mit einem Umdrehungszähler-System 1.

- Nach dem Start des Messzyklus
- liest die Elektronik 6 im ersten Schritt den Winkelsensor WS 3 und den Umdrehungszahl-Sensor US 2 aus und
- speichert im 2. Schritt in den Speicher 8 den WS-Messwert W8 (8a) und in den Speicher 9 die US-Messwerte als Tabelle T9 (9a);
- im 3. Schritt wird von der Verarbeitungseinheit 11 aus dem Winkelsensor-Messwert der zugehörige Feldwinkel-Quadrant Q1, Q2, Q3 oder Q4 ermittelt;
- im 4. Schritt wird für den ermittelten Quadranten (z.B. Q1) aus dem Speicher 10 mit den Sollwert-SPF die Subtabelle (z.B. S1Q1 (10a)) für den ermittelten Quadranten geladen für die zulässigen Umdrehungen i ($0 \leq i \leq n$);
- im 5. Schritt wird von der Verarbeitungseinheit 11 der Laufindex i auf 0 gesetzt;
- der 6. Schritt ist ein iterativer Vergleich durch die Verarbeitungseinheit 11 zwischen den Messwerten 9a mit den Sollwerten (z.B. 10a) für die Umdrehung i:

  ◦ Stimmen die Werte überein, so gibt die Ausleseelektronik im 7. Schritt die Umdrehungszahl i aus und beendet den Messzyklus oder
  ◦ Wenn die Werte nicht übereinstimmen, so wird im 7. Schritt der Laufindex i um eins erhöht und
  ◦ im 8. wird Schritt geprüft, ob i > n ist:

    Wenn i > n ist folgt im 9. Schritt die Fehlerdetektion,
    ansonsten wird der 6. Schritt wiederholt für die Umdrehung i+1;

- Für die Fehlerdetektion setzt die Verarbeitungseinheit 11 im 9. Schritt den Laufindex i auf 0 und
- liest im 10. Schritt aus dem Speicher 12 mit den Sollwert-Fehler-SPF für die Umdrehung i die m(i) ($0 \le j \le m$) Subtabellen (z.B. SF1Q1 (12a)) der m vorberechneten Fehler ein;
- im 11. Schritt wird der Laufindex j auf 0 gesetzt
- der 12. Schritt ist ein Vergleich zwischen den Messwerten 9a mit der Sollwert-Fehler-SPF für den Fehlerzustand j (z.B. aus Subtabelle SF1Q1 (12a)) für die Umdrehung i:

  ○ Stimmen die Werte überein, so gibt die Ausleseelektronik im 13. Schritt die Umdrehungszahl i aus und einen Fehlerwert für den Fehlerzustand und beendet den Messzyklus
  ○ Wenn die Werte nicht übereinstimmen, so wird im 14. Schritt der Laufindex j um eins erhöht und
  ○ im 15. Schritt wird geprüft, ob j > m ist:

    Wenn $j \le m$ ist wird der 12. Schritt wiederholt für den vorberechneten Fehler j+1;
    Wenn j > m ist, folgt im 16. Schritt die Abfrage, ob der Laufindex i > n ist:

    - Wenn ja, dann erfolgt im 17. Schritt die Ausgabe nur eines Fehlerwertes und die Beendigung des Messzyklus,
    - Wenn nein wird im 17. Schritt der Laufindex i um eins erhöht und der Schritt 10 wiederholt

- Der Messzyklus ist mit der Ausgabe einer Umdrehungszahl (Schritt 7) oder der Ausgabe von einer Umdrehungszahl mit einem Fehlerwert (Schritt 13) oder der Ausgabe von nur einem Fehlerwert (Schritt 17) beendet.

Die Ausgabe eines Fehlerwertes und einer gültigen Umdrehungszahl setzt voraus, dass ein MM initialisiert war, dass auch noch im Fehlerzustand die Bestimmung einer gültigen Umdrehungszahl ermöglicht.

Figur 3 zeigt schematisch drei Sensorelement-Geometrien, die konstante DW-Anzahl ermöglichen mit einem Magnetisierungsmuster (MM) bestehend aus zwei DW.

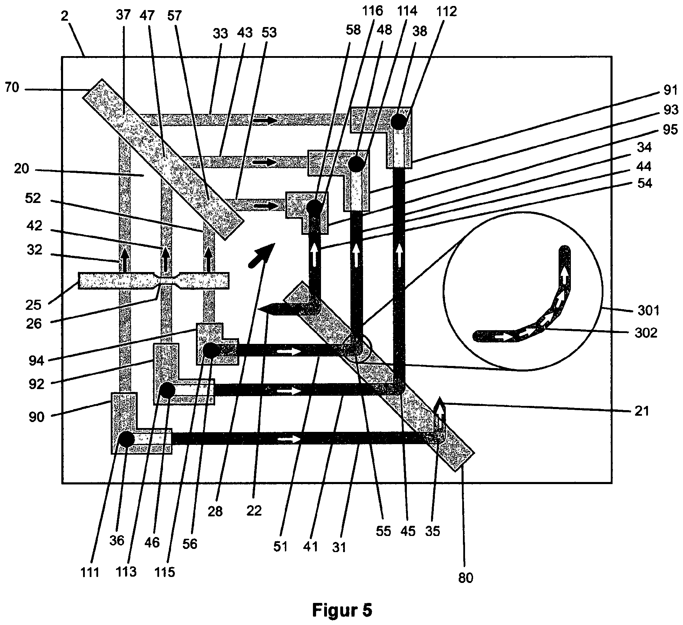

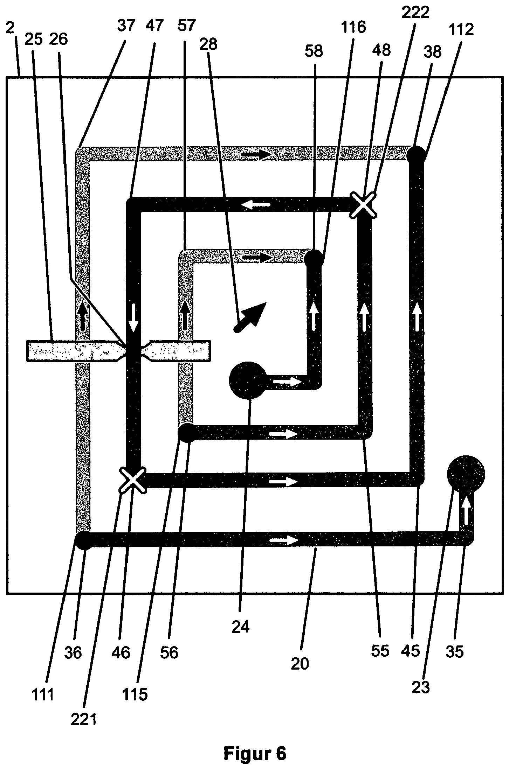

Figur 3a zeigt schematisch eine fünfwindige Spirale mit zwei Spitzen an den Spiralenenden, dargestellt durch eine lange horizontale Linie mit senkrechten Markierungen. Jede senkrechte Markierung symbolisiert eine DW-Lage (vgl. viertelkreis-ähnlicher Polygonzug 302 in Figur 5) in einer quadratischen Spirale, die langen Markierungen symbolisieren ganze Umdrehungen, die mittellangen Markierungen die halben Umdrehungen und die kurzen Markierungen 90°- bzw. 270°-Feldwinkel-Inkremente innerhalb einer Umdrehung von 360°. Domänenwände werden durch die dicken schwarzen senkrechten Linien symbolisiert. Die weißen Bereiche auf der horizontalen Linie symbolisieren die Magnetisierung in ccw-Richtung und die grauen Bereiche der horizontalen Linie symbolisieren die Magnetisierung in cw-Richtung. Domänenwände halten sich zeitlich betrachtet überwiegend in den Viertelkreisen (DW-Lagen, siehe Figur 6) auf. Sie sind deshalb positioniert in den Viertelkreisen, symbolisiert durch die senkrechten Markierungen. Das MM mit den beispielhaften zwei Domänenwänden hat einen Winkelabstand von 180° zwischen den Domänenwänden. Das MM kann innerhalb der Spirale beliebig oft von ganz links über die eingezeichnete Position nach ganz rechts und zurück bewegt werden. Damit das MM nicht aus dem Sensorelement heraus transportiert wird, benötigt das Sensorelement an sich bekannte, nicht dargestellte mechanische Endanschläge.

Figur 3b zeigt schematisch eine fünfwindige Spirale mit zwei Domänenwandgeneratoren (DWG) an den Spiralenenden, dargestellt durch eine lange horizontale Linie mit senkrechten Markierungen und außen zwei Kreisen für die DWG. Die DW-Lagen und Magnetisierungen sind symbolisiert wie zu Figur 3a beschrieben. Das MM mit hier zwei DW-Lücken (DWL), symbolisiert durch je ein Kreuz, hat einen Winkelabstand von 180° zwischen den DWL und von 540° zwischen den Domänenwänden, die an die DWL angrenzen. Das MM mit den zwei DWL kann innerhalb der Spirale beliebig oft von ganz links über die eingezeichnete Position nach ganz rechts und zurück bewegt werden. Dabei darf eine DW-Lücke an den DWG angrenzen wie in Figur 3j gezeigt. Die DW-Anzahl bleibt beim Transport des MM konstant. Bewegt sich das MM nach rechts, so werden am rechten DWG pro halber Umdrehung eine DW annihiliert mit einer vom DWG erzeugten DW und zugleich wird vom linken DWG eine DW links in die Spirale injiziert. Damit das MM nicht aus dem Sensorelement heraus transportiert wird, benötigt das Sensorelement wiederum genannte mechanische Endanschläge.

Figur 3c zeigt schematisch eine fünfwindige geschlossene Schleife, dargestellt durch einen Kreis mit senkrecht zum Kreis stehenden Markierungen, die wie in Figur 3a, die DW-Lagen symbolisieren. Das MM mit zwei Domänenwänden hat einen Winkelabstand von 180° zwischen den Domänenwänden, bzw. von 1620° (4,5 Windungen). Das MM kann beliebig oft cw oder ccw durch die Schleife transportiert werden. Ein derart ausgebildetes Sensorelement benötigt keine mechanischen Endanschläge.

Figur 3d zeigt das Sensorelement von Figur 3c in einer geometrisch modifizierten, platzsparenden Darstellung. Die fünf Windungen werden dargestellt wie in Figur 3a. Der untere Bogen symbolisiert den Verbindungssteg von der äußeren Windung zur inneren Windung, der aus einer Spirale eine geschlossene Schleife mit Kreuzungen macht (vgl.

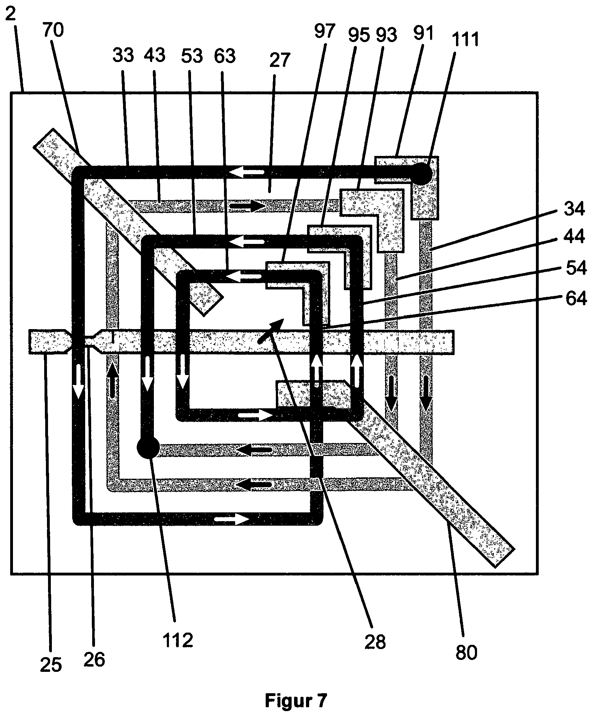

Steg 64 in Figur 7).

Die Figuren 3e bis 3i zeigen das Sensorelement aus Figur 3a mit dem MM an fünf verschiedenen Positionen, die die Umdrehungszahl 0 (Figur 3e), 1 (Figur 3f), 2 (Figur 3g), 3 (Figur 3h) und 4 (Figur 3i) repräsentieren. Diese Zuordnung hängt von der Applikation und nicht vom Sensorelement ab. Anstatt von 0 bis 4 Umdrehungen könnten die gleichen MM-Positionen in einer anderen Applikation die Umdrehungen -2 bis +2 repräsentieren. Ausgehend von der MM-Position in Figur 3e wird das MM mit jeder Umdrehung um vier DW-Lagen (entsprechend einer Windung) weiter transportiert in cw-Richtung. Das MM aus zwei Domänenwänden mit einem Winkelabstand von 180° bleibt dabei unverändert.

Die Figuren 3j bis 3l zeigen schematisch, wie das MM aus Figur 3b aussieht, wenn es in den Positionen lokalisiert ist, die die Umdrehungszahl 0, 1 und 2 repräsentieren. Das MM mit den zwei DWL bleibt beim Transport durch das Sensorelement unverändert. Ebenso die Gesamtanzahl an Domänenwänden. Wenn das MM nach rechts transportiert wird, verschwinden rechts mit jeder Umdrehung zwei Domänenwände und es kommen links zwei neue Domänenwände hinzu.

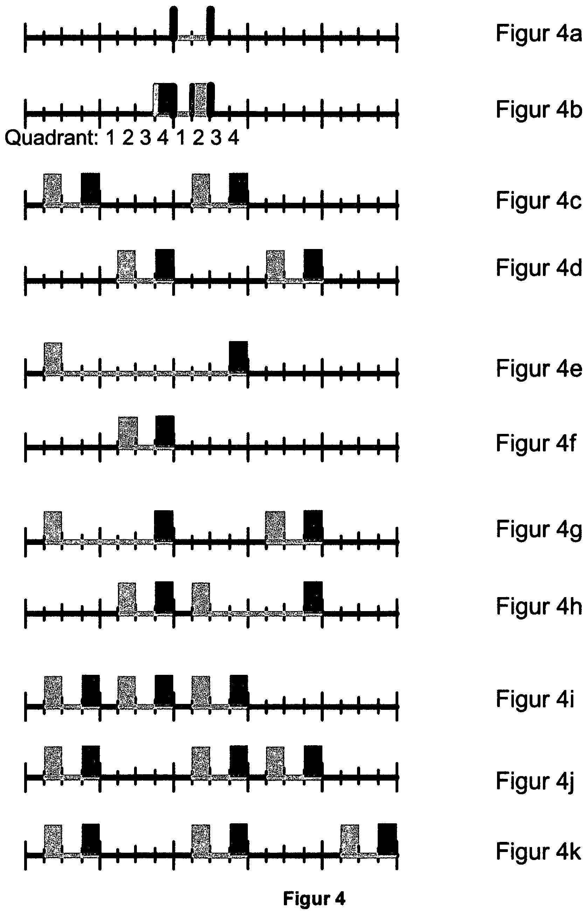

Figur 4 zeigt Magnetisierungsmuster (MM) in einer beispielhaften fünfwindigen, quadratischen Spirale mit zwei Spitzen. Es wird gezeigt, wie sich die Hysterese auf die DW-Positionen innerhalb eines MM's auswirkt (Figur 4a und 4b). Figur 4c und 4d zeigen zwei fehlerfreie MMs und die Figuren 4e bis 4k MM mit beispielhaften Fehlerzuständen. Es wird weiter nachstehend beschrieben ob diese MM im Fehlerzustand die Bestimmung der Umdrehungszahl ermöglichen oder nicht.

Figur 4a zeigt das MM von Figur 3a mit zwei Domänenwänden in einer Position, die z.B. die Umdrehung Null repräsentiert. Die zwei DW sind in zwei DW-Lagen mit einem Winkelabstand von 180° zueinander positioniert.

Figur 4b zeigt das MM von Figur 4a mit einer Hysterese von ±45°, wobei die Hysterese durch ein graues Rechteck symbolisiert wird. Die ±45°-Hysterese umfasst 90°, d.h. einen Quadranten. Die Quadranten werden vorzugsweise so zur Spirale angeordnet (Figur 5 zeigt eine solche typische Spirale), dass der Feldwinkel, der die "0°-Lage" der Hysterese repräsentiert, senkrecht zu einem Steg steht. Hierdurch zeigen die Feldwinkel, die die Hysteresegrenzen repräsentieren, auf die zwei DW-Lagen, die diesen Steg umfassen. Durch diese Anordnung der Quadranten zur quadratischen Spirale repräsentieren die vier Quadranten innerhalb einer Windung jeweils einen Steg und die Hysterese jede DW-Position auf diesem Steg einschließlich der Hälfte der angrenzenden DW-Lagen, in denen sich die DW zeitlich betrachtet überwiegend aufhalten. Mit dicken senkrechten Linien symbolisiert sind in Figur 4b die DW-Positionen von Figur 4a und mit dünnen, senkrechten Linien die DW-Positionen in den DW-Lagen am anderen Ende des zugehörigen Steges. Im regulären, fehlerfreien Betrieb durchläuft eine DW den Steg zwischen zwei DW-Lagen innerhalb weniger 100 ns. DW-Positionen innerhalb des Steges sind durch das graue Rechteck symbolisiert. Wenn dieser Steg Teil einer Wheatstone-Halbbrücke ist, so sind die zulässigen Signalpegel im Quadranten 1 und 2 Highpegel oder Mediumpegel, symbolisiert durch das hellgraue Rechteck, und im Quadranten 3 und 4 Mediumpegel oder Lowpegel, symbolisiert durch das dunkelgraue Rechteck (wobei die Referenzrichtung so liegt, wie in den Figuren 5 bis 7 gezeigt).

Figur 4c zeigt ein MM mit vier Domänenwänden in einer Position, die z.B. die Umdrehung Null repräsentiert. Ausgegeben wird von der Ausleseelektronik die Umdrehungszahl Null. Die Winkelabstände im MM sind zwischen der DW links außen und der DW links innen 180°, zwischen der DW links innen und der DW rechts innen 540° und zwischen der DW rechts innen und rechts außen 180°, insgesamt 900° zwischen den äußeren Domänenwänden. Die Domänenwände sind durch Rechtecke symbolisiert, die sämtliche DW-Positionen auf einem Steg beinhalten, entsprechend einer zulässigen Hysterese von ±45°. Hellgraue Rechtecke symbolisieren wie in Figur 4b High- oder Mediumpegel und dunkelgraue Rechtecke Medium- oder Lowpegel der Wheatstone-Halbbrücke.

Figur 4d zeigt das MM aus Figur 4c nach einer cw-Umdrehung. Alle vier Domänenwände sind jeweils vier DW-Lagen (Viertelkreise) weiter transportiert worden. Die Winkelabstände im MM bleiben gleich. Diese MM-Position repräsentiert die Umdrehungszahl 1. Ausgegeben wird von der Ausleseelektronik die Umdrehungszahl eins. Die Domänenwände sind, wie in Figur 4c, symbolisiert durch hellgraue und dunkelgraue Rechtecke.

Figur 4e zeigt ein MM mit zwei Domänenwänden mit einem Winkelabstand von 900° an Positionen, die auch die äußeren Domänenwände in Figur 4c besetzen. Wenn in Figur 4e das initialisierte MM das MM von Figur 4c war, dann annihilierten zwischen der Messung des MM von Figur 4c und der Messung von Figur 4e zwei Domänenwände. Aufgrund des Winkelabstandes von 900° kann aus dem MM von Figur 4e plausibel die Umdrehungszahl Null ermittelt werden. In vorteilhaften Ausgestaltungen gibt die Ausleseelektronik die Umdrehungszahl Null und einen Fehlerwert aus. Die Domänenwände sind, wie in Figur 4c, symbolisiert durch hellgraue und dunkelgraue Rechtecke.

Figur 4f zeigt ein MM mit zwei Domänenwänden mit einem Winkelabstand von 180°. Wenn in Figur 4f das initialisierte MM das MM von Figur 4c war, dann annihilierten zwischen der Messung des MM von Figur 4c und der Messung von Figur 4f zwei Domänenwände. Aufgrund des Winkelabstandes von 180° ist aus dem MM von Figur 4f keine Umdrehungszahl plausibel zu ermitteln. In vorteilhaften Ausgestaltungen gibt die Ausleseelektronik einen Fehlerwert aus. Die Domänenwände sind, wie in Figur 4c, symbolisiert durch hellgraue und dunkelgraue Rechtecke.

Figur 4g zeigt ein MM mit vier Domänenwänden mit einem Winkelabstand von 1260° zwischen den äußeren DW und von 180° zwischen der DW rechts außen und der DW rechts innen. Anhand dieser zwei Domänenwände kann plausibel die Umdrehungszahl eins ermittelt werden. In vorteilhaften Ausgestaltungen gibt die Ausleseelektronik die Umdrehungszahl eins und einen Fehlerwert aus. Gegenüber dem MM in Figur 4c ist die DW links außen in der gleichen Position. Sie ist nicht cw verschoben um 360° (4 DW-Lagen), wie die anderen drei Domänenwände, sondern war während der cw-Umdrehung gepinnt. Die Domänenwände sind, wie in Figur 4c, symbolisiert durch hellgraue und dunkelgraue Rechtecke.

Figur 4h zeigt ein MM mit vier Domänenwänden mit einem Winkelabstand von 900° zwischen den äußeren DW und von 180° zwischen der DW links innen und der DW links außen. Anhand dieser zwei Domänenwände kann plausibel die Umdrehungszahl eins ermittelt werden. In vorteilhaften Ausgestaltungen gibt die Ausleseelektronik die Umdrehungszahl eins und einen Fehlerwert aus. Verglichen mit dem MM in Figur 4c ist die DW rechts innen in der gleichen Position. Sie ist nicht cw verschoben um 360° (4 DW-Lagen), wie die anderen drei Domänenwände, sondern war während einer cw-Umdrehung gepinnt. Die Domänenwände sind, wie in Figur 4c, symbolisiert durch hellgraue und dunkelgraue Rechtecke.

Figur 4i zeigt ein MM mit sechs DW mit einem Winkelabstand von 900° zwischen den äußeren Domänenwänden und von 180° zwischen je zwei benachbarten Domänenwänden. Anhand der beiden äußeren Domänenwände kann plausibel die Umdrehungszahl Null ermittelt werden. In vorteilhaften Ausgestaltungen gibt die Ausleseelektronik die Umdrehungszahl Null und einen Fehlerwert aus. Verglichen mit dem MM in Figur 4c sind zwei Domänenwände innerhalb des ursprünglichen MM's durch DW-Nukleation hinzugekommen. Die Domänenwände sind, wie in Figur 4c, symbolisiert durch hellgraue und dunkelgraue Rechtecke.

Figur 4j zeigt ein MM mit sechs DW mit einem Winkelabstand von 1260° zwischen den äußeren DW und von 180° zwischen der DW links innen und der DW links außen und von 540° zwischen der DW links innen und der DW links Mitte, sowie von 180° zwischen der DW links Mitte und der DW rechts Mitte. Anhand dieser vier DW, die die Positionen der vier DW in Figur 4c einnehmen, kann plausibel die Umdrehungszahl Null ermittelt werden. In vorteilhaften Ausgestaltungen gibt die Ausleseelektronik die Umdrehungszahl Null und einen Fehlerwert aus. Verglichen mit dem MM in Figur 4c sind zwei DW außerhalb des ursprünglichen MM's durch DW-Nukleation hinzugekommen. Die Domänenwände sind, wie in Figur 4c, symbolisiert durch hellgraue und dunkelgraue Rechtecke.

Figur 4k zeigt ein MM mit sechs Domänenwänden mit einem Winkelabstand von 1620° zwischen den äußeren Domänenwänden. Verglichen mit dem MM in Figur 4a sind zwei Domänenwände durch DW-Nukleation außerhalb des ursprünglichen MM's hinzugekommen mit einem Winkelabstand von 540° und 720° zur DW rechts außen in Figur 4a, die jetzt die DW Mitte rechts im MM ist. Aufgrund der Winkelabstände im MM von Figur 4i ist plausibel keine Umdrehungszahl zu ermitteln. In vorteilhaften Ausgestaltungen gibt die Ausleseelektronik in diesem Fall nur einen Fehlerwert aus. Die Domänenwände sind, wie in Figur 4c, symbolisiert durch hellgraue und dunkelgraue Rechtecke.

Die nachfolgenden Figuren 5 bis 7 zeigen in Draufsicht beispielhaft reale Sensorelement-Geometrien, die den Betrieb mit MM mit konstanter DW-Anzahl ermöglichen: Diese Beispiel zeigen schematisch: eine dreiwindige Spirale mit zwei Spitzen mit einer 180°-Kontaktierung (Figur 5), eine dreiwindige Spirale mit zwei DWG (Figur 6) und eine vierwindige, quadratische Schleife mit einer erfindungsgemäßen 360°-Kontaktierung (Figur 7). Zugunsten einer besseren Übersicht sind die beispielhaften Umdrehungssensoren nur mit den Details dargestellt, die zur jeweiligen Figur nachstehend erläutert werden.

Figur 5 zeigt eine erfindungsgemäße Ausgestaltung eines Umdrehungssensors 2. Das Sensorelement soll im Beispiel eine dreiwindige, quadratische Spirale 20 sein, deren Enden angespitzt sind. Die Spitze 21 ist das Ende der äußeren Windung und die Spitze 22 das Ende der innersten Windung. Die Spirale besteht aus einem magnetischen Schichtstapel, der den GMR-Effekt zeigt. Die Referenzrichtung 28 liegt diagonal zu den quadratischen Windungen. Die erste, äußerste Windung besteht aus den Stegen 31, 32, 33 und 34, die zweite, mittlere Windung aus den Stegen 41, 42, 43 und 44 und die dritte, innerste Windung aus den Stegen 51, 52, 53 und 54 (im Uhrzeigersinn). Jeder Steg steht im 90°-Winkel zum nachfolgenden Steg. Die Verbindung zwischen den Stegen sind Viertelkreise oder viertelkreis-ähnliche Polygonzüge 302 (gezeigt im gezoomten Kreis 301), gebildet aus demselben Schichtstapel wie genannte Stege selbst. Diese Polygonzüge sind die "Ecken" der quadratischen Spirale und zugleich die Domänenwand-Lagen (DW-Lagen). Die erste, äußerste Windung beinhaltet die DW-Lagen 35, 36, 37 und 38, die zweite Windung die DW-Lagen 45, 46, 47 und 48 und die dritte Windung die DW-Lagen 55, 56, 57 und 58.

Die Spirale ist mit elektrischen Kontakten im "180°-Kontaktierungsschema" versehen: Es gibt einen gemeinsamen gnd-Kontakt 70 links oben, einen gemeinsamen Vcc-Kontakt 80 rechts unten und drei Mittelkontakte 91, 93 und 95 rechts oben sowie drei Mittelkontakte 90, 92 und 94 links unten, sowie eine Leiterbahn 25 mit einer Verengung 26 zum Initialisieren des Sensorelementes. Der Magnetisierungszustand des Sensorelementes wird durch Potentialmessung mit sechs Wheatstone-Halbbrücken ausgelesen. Links unten sind die drei Halbbrücken mit den Mittelkontakten 90, 92 und 94:

- Die Wheatstone-Halbbrücke W1-1 bilden die Stege 31 und 32 mit dem Mittelkontakt 90, dem gnd-Kontakt 70 und dem Vcc-Kontakt 80 ;
- Die Wheatstone-Halbbrücke W2-1 bilden die Stege 41 und 42 mit dem Mittelkontakt 92, dem gnd-Kontakt 70 und dem Vcc-Kontakt 80 ;

- Die Wheatstone-Halbbrücke W3-1 bilden die Stege 51 und 52 mit dem Mittelkontakt 94, dem gnd-Kontakt 70 und dem Vcc-Kontakt 80.

Rechts oben sind die drei Halbbrücken mit den Mittelkontakten 91, 93 und 95:

- Die Wheatstone-Halbbrücke W1-2 bilden die Stege 33 und 34 mit dem Mittelkontakt 91, dem gnd-Kontakt 70 und dem Vcc-Kontakt 80 ;
- Die Wheatstone-Halbbrücke W2-2 bilden die Stege 43 und 44 mit dem Mittelkontakt 93, dem gnd-Kontakt 70 und dem Vcc-Kontakt 80 ;
- Die Wheatstone-Halbbrücke W3-2 bilden die Stege 53 und 54 mit dem Mittelkontakt 95, dem gnd-Kontakt 70 und dem Vcc-Kontakt 80.

Das Sensorelement 2 ist hier zunächst komplett gefüllt mit sechs DW (z.B. nach einem Feldpuls mit einer Feldstärke über der Nukleationsfeldstärke des Sensorelementes 2):

- In der ersten, äußersten Windung sind die DW 111 in der DW-Lage 36 und die DW 112 in der DW-Lage 38 lokalisiert,
- In der zweiten, mittleren Windung sind die DW 113 in der DW-Lage 46 und die DW 114 in der DW-Lage 48 lokalisiert,
- In der dritten, innersten Windung sind die DW 115 in der DW-Lage 56 und die DW 116 in der DW-Lage 58 lokalisiert.

Die drei Halbbrücken sind durch diese DW-Positionen und der Lage der Referenzrichtung 28 im Mittelpotential. Die Magnetisierungsrichtung in ccw-Richtung ist dunkelgrau und die Magnetisierungsrichtung in cw-Richtung ist hellgrau dargestellt. Zusätzlich ist für jeden Steg die Magnetisierungsrichtung mit einem Pfeil gekennzeichnet. Die Referenzrichtung 28 des GMR-Schichtstapels ist diagonal zur quadratischen Spirale und zeigt von links unten nach rechts oben.

Das in Figur 5 gezeigte Magnetisierungsmuster mit sechs DW ist zum Zählen von Umdrehungen noch nicht geeignet. Es müssen erst noch DW gelöscht werden. Die ansonsten identische Löschungsprozedur soll anhand einer Spirale mit zwei Domänenwandgeneratoren an den Enden beschrieben werden, wie sie in Figur 6 dargestellt ist, um hier gleich eine weitere Ausführungsmöglichkeit des eigentlichen Sensorelements abzuhandeln.

Figur 6 zeigt eine Variante des Sensorelementes 2. Das Sensorelement 2 ist eine dreiwindige, quadratische Spirale 20, an deren Enden Domänenwandgeneratoren 23 und 24 positioniert sind. Es trägt ein Magnetisierungsmuster (MM) mit 2 DW-Lücken (DWL) 221 und 222, visualisiert durch je ein Kreuz. Vor der Löschung befanden sich die DW 113 und DW 114 (in Fig. 6 nicht mehr dargestellt - vgl. dazu Figur 5) an den Positionen der DWL 221 und DWL 222. Die Initialisierung erfolgt, ohne auf Details einzugehen, z.B. in zwei Schritten:

1. Entweder Nukleation von DW mit einem Magnetfeldpuls mit einer Feldstärke oberhalb der Nuklationsfeldstärke mit Feldrichtung entlang der Spiralendiagonalen (z.B. von links unten nach rechts oben) oder ein Drehen des Magnetfeldes vom Sensorsystem um mindestens n+1 Umdrehungen bei einer n-windigen-Spirale in cw-Richtung oder ccw-Richtung (hier 4 Umdrehungen). Hierdurch wird die Spirale vom Domänenwandgenerator DWG 23 (oder vom DWG 24) komplett mit DW gefüllt.

2. DW-Annihilation von zwei DW unter der Verengung 26 der Leiterbahn 25 mithilfe eines hinreichend großen Oerstedtfeldes, wodurch zwei DW-Lücken DWL 221 und DWL 222 entstehen, die dann in die gewünschte Nullposition transportiert werden.

Anstelle der Spitzen 21 und 22 des in Figur 5 dargestellten Sensorelementes ist die quadratische Spirale 20 in Figur 6 mit zwei Domänenwandgeneratoren (DWG) 23 und 24 an den Enden versehen. Zur Bestimmung der Umdrehungszahl werden die Positionen der DW 112 und/oder der DW 115 in der gemessenen SPF ermittelt. Die elektrische Kontaktierung für eine Spirale mit zwei DWG ist immer die "180°-Kontaktierung" (siehe Figur 5) und wurde in der Fig. 6, der besseren Übersichtlichkeit wegen, weggelassen. Die Referenzrichtung 28 des GMR-Schichtstapels ist diagonal zur quadratischen Spirale und zeigt von links unten nach rechts oben.

Figur 7 zeigt eine weitere erfindungsgemäße Ausgestaltung eines Umdrehungssensors 2, bestehend aus einer vierwindigen, geschlossenen Schleife 27. Initialisiert wurde mit der Leiterbahn 25 mit der Verengung 26 im Beispiel ein MM mit zwei DW 111 und DW 112 mit einem Winkelabstand von 540°. Die Referenzrichtung 28 des GMR-Schichtstapels ist auch hier diagonal zur quadratischen Spirale und zeigt von links unten nach rechts oben. Elektrisch kontaktiert wird diese Schleife analog zur Spirale in Figur 5 allerdings mit einer "360°-Kontaktierung", bestehend aus einem gemeinsamen gnd-Kontakt 70, einem gemeinsamen Vcc-Kontakt 80 und vier Mittelkontakten 91, 93, 95 und 97, die in einer Hälfte rechts der Linie Vcc-Kontakt bis gnd-Kontakt lokalisiert sind. Der Magnetisierungszustand des Sensorelementes wird durch Potentialmessung mit vier Wheatstone-Halbbrücken ausgelesen:

- Die Wheatstone-Halbbrücke WHB1 bilden die Stege 33 und 34 mit dem Mittelkontakt 91, dem gnd-Kontakt 70 und dem Vcc-Kontakt 80 ;
- Die Wheatstone-Halbbrücke WHB2 bilden die Stege 43 und 44 mit dem Mittelkontakt 93, dem gnd-Kontakt 70 und dem Vcc-Kontakt 80 ;
- Die Wheatstone-Halbbrücke WHB3 bilden die Stege 53 und 54 mit dem Mittelkontakt 95, dem gnd-Kontakt 70 und dem Vcc-Kontakt 80 ;
- Die Wheatstone-Halbbrücke WHB4 bilden die Stege 63 und 64 mit dem Mittelkontakt 97, dem gnd-Kontakt 70 und dem Vcc-Kontakt 80.

Die vier Wheatstone-Halbbrücken WHB1 bis WHB4 korrelieren zugleich mit den Windungen W1 bis W4.

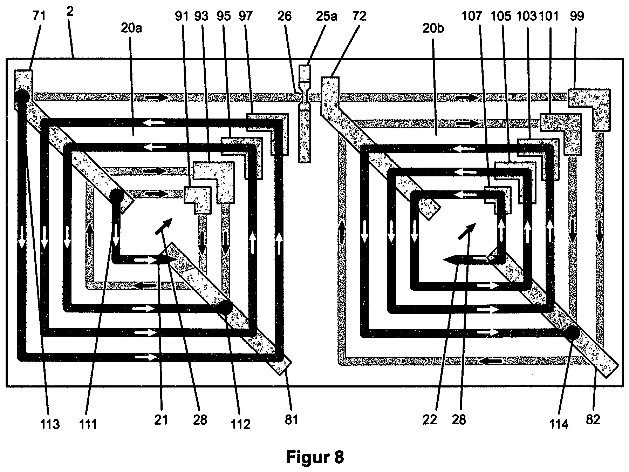

Figur 8 zeigt eine weitere beispielhafte erfindungsgemäße Ausgestaltung eines Sensorelementes 2 zur Messung von Umdrehungen. Das Sensorelement 2 soll im Beispiel aus zwei Teilspiralen 20a und 20b bestehen mit den Spitzen 21 und 22 und mit je vier Windungen und mit einer "360°-Kontaktierung", bestehend aus den Kontakten 71 (gnd), 81 (Vcc), 91, 93, 95 und 97 (Mittelkontakte) auf der Teilspirale 20a, sowie 72 (gnd), 82 (Vcc), 99, 101, 103, 105 und 107 (Mittelkontakte) auf der Teilspirale 20b, wurden vier Domänenwände DW 111, DW 112, DW 113 und DW 114 initialisiert. In dieser Ausgestaltung bilden diese vier Domänenwände zwei logische Magnetisierungsmuster mit je zwei Domänenwänden: DW 111 und DW 112 bilden ein MM in der Teilspirale 20a, sowie DW 113 und DW 114 bilden ein zweites MM. Jedes MM befindet sich im dargestellten Beispiel in der "Nullposition" und kann drei Umdrehungen cw bewegt werden. Der Winkelabstand zwischen DW 111 und DW 112, sowie zwischen DW 113 und DW 114 beträgt jeweils 540°, der Winkelabstand zwischen DW 112 und DW 113 beträgt 900°. Durch diese zwei logischen MMs wird diese Ausgestaltung zu einem Umdrehungszähler mit redundanter Umdrehungszählung auf einem Chip, der drei Umdrehungen zählen kann. Für die Initialisierung dient die Leiterbahn 25 mit der Einengung 26. Die Referenzrichtung 28 des GMR-Schichtstapels ist diagonal zu den quadratischen Spiralen gerichtet und zeigt jeweils von links unten nach rechts oben. Die Messergebnisse der zwei Teilspiralen werden von der Ausleseelektronik (6) (vgl. Figur 1) ausgewertet. Nur wenn die Ausleseelektronik aus den gemessenen Teil-SPFs beider Teilspiralen die gleiche Umdrehungszahl ermittelt, liefert die Messung ein zweifach redundantes Ergebnis. Im Falle eines Fehler-Ereignisses in einer Spirale kann die Ausleseelektronik die Umdrehungszahl immer aus dem SPF der Spirale ermitteln, bei der die Ausleseelektronik einen gültigen Zustand erkennt (Übereinstimmung mit einem Sollwertmuster). Das andere SPF führt zu einem Fehlerwert. Bei geeignetem MM, z.B. den MM aus Figur 4c, kann dann trotz eines Fehlerzustands immer noch die Umdrehungszahl ermittelt werden (Übereinstimmung mit einem Fehler-Sollwertmuster), so dass die Umdrehungszahl dann trotz des Fehlerzustandes auch zweifach redundant ermittelt wird.

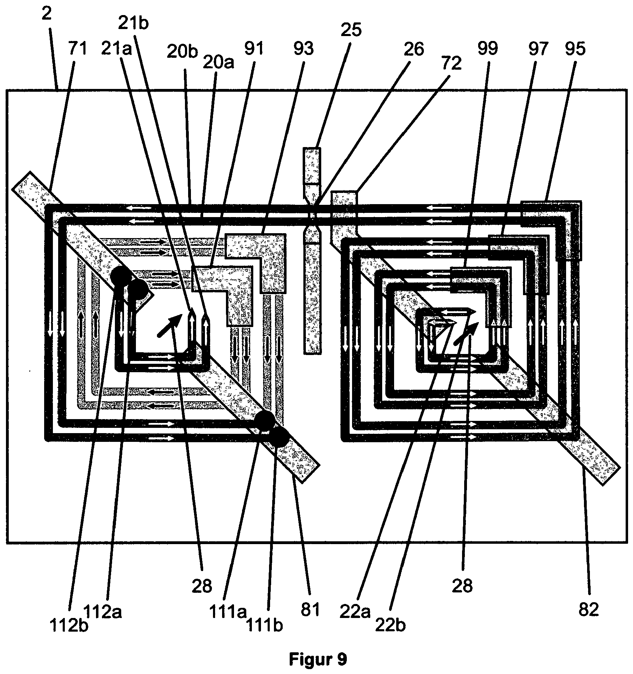

Figur 9 zeigt eine weitere beispielhafte erfindungsgemäße Ausgestaltungsmöglichkeit eines Sensorelementes zur Messung von drei Umdrehungen. Zwei ineinander geführte Spiralen 20a (innere Spirale) und 20b (äußere Spirale) mit den Spitzen 21a und 22a bzw. 21b und 22b und mit je vier Windungen und einer gemeinsamen 360°-Kontaktierung, bestehend aus den Kontakten 71 (gnd), 81 (Vcc), 91, 93 (Mittelkontakte) auf den Teilspiralen links, sowie 72 (gnd), 82 (Vcc), 95, 97 und 99 (Mittelkontakte) auf den Teilspiralen rechts bilden einen Umdrehungszähler, die zweifache Redundanz erhält man hier durch die parallel geführte Doppelspirale. Die Referenzrichtung 28 des GMR-Schichtstapels ist diagonal zur quadratischen Spirale und zeigt von links unten nach rechts oben. Für die Initialisierung dient die Leiterbahn 25 mit der Einengung 26. Initialisiert ist im Beispiel ein MM mit je einem DW-Paar DW 111a und DW 112a in der Spirale 20a sowie DW 111b und DW 112b in der Spirale 20b mit einem jeweiligen Winkelabstand von 540°. Im gültigen Zählbetrieb liefert dieses Sensorelement die Signalpegel High-Pegel (100%-Pegel), Medium-Pegel (50%-Pegel) und Low-Pegel (0% Pegel). Im Falle eines DW-Pinning-Ereignisses, dass zu einer Änderung des Winkelabstandes zwischen zwei DW führt, entstehen zwei neue Pegel: 75%-Pegel und 25%-Pegel, die der Ausleseelektronik anzeigen, dass ein Fehler aufgetreten ist. Die Ausleseelektronik muss diese Pegel zweifelsfrei detektieren können. Sie kann trotzdem eine gültige Umdrehungszahl anhand des SPFs mit den 75%-Pegel oder 25%-Pegel ermitteln, da ein DW-Paar in einer Spirale (z. B. der Spirale 20a) fehlerfrei transportiert wurde. D.h. statt z.B. High-Pegel ist im SPF ein 75%-Pegel und statt eines Low-Pegels ist ein 25%-Pegel im SPF vorhanden. Die vorgehaltenen Sollwertmuster und Fehler-Sollwertmuster sind angepasst an die fünf Signalpegel dieses Sensorelementes.

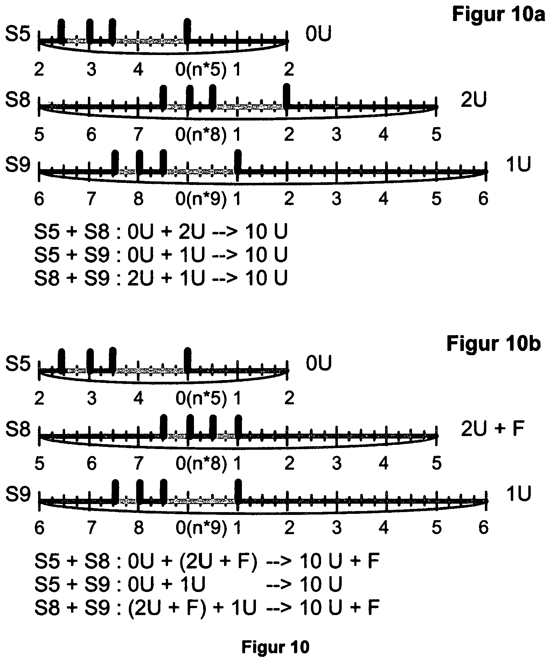

Figur 10 zeigt schematisch eine erfindungsgemäße Ausgestaltung eines Sensorelementes zur Zählung von 40 Umdrehungen (U) in einer beispielhaften Applikation. Das Sensorelement enthält drei Schleifen mit den teilerfremden maximalen Umdrehungszahlen 5 (S5), 8 (S8) und 9 (S9). In der Draufsicht sind dies quadratische Schleifen, wie in Figur 7 beispielhaft gezeigt, die hier platzsparend dargestellt sind. Die Schleifen, DW-Lagen und Domänenwände werden symbolisiert wie in Figur 3d. Für eine nicht redundante Umdrehungszählung benötigt man die Schleifen S5 und S8, die kombiniert bis 40 Umdrehungen zählen: 5U * 8U = 40U. Durch Hinzunahme der Schleife S9 zur redundanten Umdrehungszählung gibt es drei Kombinationen von je zwei Schleifen, die mindestens 40 Umdrehungen zählen können.

Figur 10a zeigt beispielhaft für die Umdrehungszahl 10U die MM-Positionen in den Schleifen S5 (Einzelschleifen-Umdrehungszahl: 0U), S8 (Einzelschleifen-Umdrehungszahl: 2U) und S9 (Einzelschleifen-Umdrehungszahl: 1U) mit einem redundanten MM mit vier DW mit den Winkelabständen 180° zwischen DW links außen und DW links innen, 180° zwischen DW links innen und DW rechts innen und 540° zwischen DW rechts innen und DW rechts außen. Die Position der DW rechts außen repräsentiert hier jeweils die Einzelschleifen-Umdrehungszahl. Für jede der drei Kombinationen der Schleifen (S5 + S8), (S5 + S9) und (S8 + S9) ermittelt die Ausleseelektronik aus den Einzelschleifen-Umdrehungszahlen jeweils die Umdrehungszahl 10U für die Schleifenkombination. Insgesamt wird die Umdrehungszahl dreifach redundant ermittelt. Entweder, indem für jede Schleifenkombination für jede Kombination von Einzelschleifen-Umdrehungszahlen die dazu gehörende Umdrehungszahl der Schleifenkombination (tabellarisch) hinterlegt ist oder, indem diese errechnet wird. In einer Applikation, die 40 Umdrehungen zählt, repräsentiert die Einzelschleifen-Umdrehungszahl

- 0U für die Schleife S5 die Umdrehungszahl 0U, 5U, 10U, 15U, 20U, 25U, 30U, 35U und 40U (allgemein n*5U),
- 2U für die Schleife S8 die Umdrehungszahl 10U, 18U, 26U und 34U (allgemein m*8U+2U),
- 1U für die Schleife S9 die Umdrehungszahl 10U, 19U, 28U und 37U (allgemein k*9U+1U).

Aufgrund der Teilerfremdheit der Schleifen untereinander, gibt es für jede Kombination von Einzelschleifen-Umdrehungszahlen immer nur genau eine Übereinstimmung, die die Umdrehungszahl der Kombination ist. Hier ist es die Umdrehungszahl 10U.

Für die Erstellung der Sollwert-SPFs müssen die korrekten MM-Positionen, bzw. die korrekten Positionen der maßgebenden DW errechnet werden. Die korrekte DW-Position ist der Rest aus der Division der Umdrehungszahl (hier 10U) mit der maximalen Umdrehungszahl der Schleife (hier 5U, 8U oder 9U):

- S5: 0U    (10/5 = 2+ Rest 0),
- S8: 2U    (10/8 = 1 + Rest 2) und
- S9: 1U    (10/9 = 1 + Rest 1)

Figur 10b zeigt für die gezählte Umdrehungszahl 10U die MM-Positionen, wenn in der Schleife S8 die DW rechts außen während einer Umdrehung gepinnt war und sich verglichen mit Figur 10a dadurch der Winkelabstand zur DW rechts innen von 540° auf 180° verkleinerte und zur DW links außen von 900° auf 540° verkleinerte. Anhand dieses Winkelabstandes von 540° detektiert die Ausleseelektronik, dass die Schleife S8 in einem Fehlerzustand (F) ist. Aufgrund des Winkelabstandes von 180° zwischen der DW links außen und der DW links innen, der unverändert ist gegenüber Figur 10a, detektiert die Ausleseelektronik plausibel die Umdrehungszahl 2U für die Schleife S8.

- S5 : 0U (10/5 = 2+ Rest 0),
- S8 : F + 2U (Fehlerzustand sowie 10/8 = 1 + Rest 2) und
- S9: 1U (10/9 = 1 + Rest 1)

Anhand des Fehlerzustandes der Schleife S8 ermittelt die Ausleseelektronik die Umdrehungszahl 10U mit den gültigen Werten der Schleifen S5 und S9 (S5 : 0U und S9: 1U). Aufgrund des redundanten MM mit vier DW kann die Ausleseelektronik trotz des Fehlerzustandes der Schleife S8 (F) deren Einzelschleifen-Umdrehungszahl 2U ermitteln und verwenden und ermittelt in der Folge für die Kombinationen der Schleifen (S5 + S8) und (S8 + S9) auch jeweils die Umdrehungszahl 10U, insgesamt dreifach redundant, aufgrund der redundanten Magnetisierungsmuster mit vier Domänenwänden in jeder Einzelschleife.

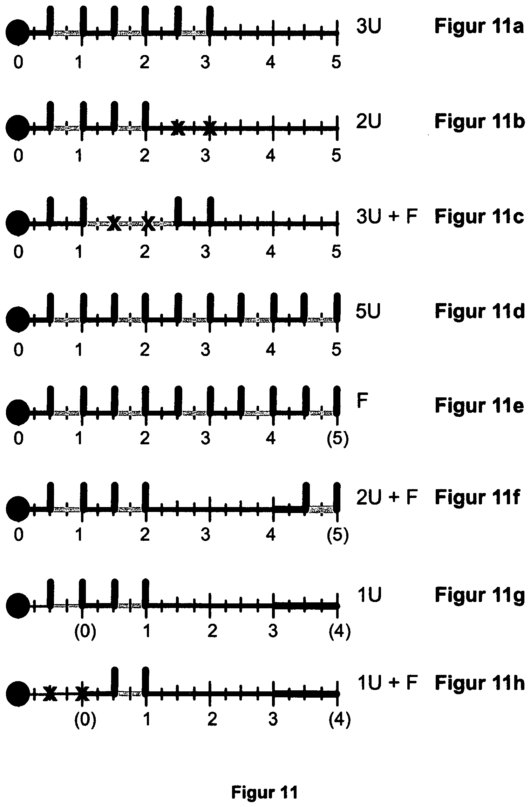

Figur 11 zeigt MM in einer fünfwindigen Spirale mit einem DWG. In der Draufsicht ist dies eine quadratische Spirale ähnlich der Spirale in Figur 6, bei der ein DWG durch eine Spitze ersetzt wurde. Die Spirale ist hier wiederum platzsparend dargestellt. Die Spirale, der DWG, die DW-Lagen, DW und DWL sind symbolisiert wie in Figur 3b geschehen. Diese Spirale ist ein vom Stand der Technik her grundsätzlich bekanntes Sensorelement (Figuren 11a bis 11e), das kombiniert wird mit der erfindungsgemäßen Ausleseelektronik, um Fehlerzustände zu detektieren. Figur 11f bis 11h zeigt gegenüber dem Stand der Technik neue Varianten, die empfindlicher in der Detektion der Fehlerzustände DW-Nukleation und DW-Annihilation sind, als die vom Stand der Technik her bekannten Spiralen in Figur 11a bis Figur 11e. Der DWG injiziert mit jeder halben Umdrehung eine DW in die Spirale, so dass im fehlerfreien Betrieb vom DWG bis zur Spitze der Spirale eine DW-Kette in der Spirale positioniert sein kann. Die DW rechts außen ist die am weitesten in die Spirale hinein transportierte DW und repräsentiert die mit dieser Ausführung maximal ermittelbare Umdrehungszahl.

Figur 11a zeigt die fünfwindige Spirale mit sechs Domänenwänden. Die DW rechts außen repräsentiert die Umdrehungszahl 3.

Figur 11b zeigt die fünfwindige Spirale mit vier Domänenwänden und zwei DWL, symbolisiert durch je ein Kreuz. Die zwei DWL rechts außen sind entstanden durch Annihilation der zwei Domänenwände rechts außen in Figur 11a. Das MM in Figur 11b repräsentiert die Umdrehungszahl 2. Der Fehlerzustand der DW-Annihilation wird nicht erkannt.

Figur 11c zeigt die fünfwindige Spirale mit vier Domänenwänden und zwei DWL, symbolisiert durch je ein Kreuz. Die zwei DWL innerhalb der DW-Kette sind entstanden durch Annihilation der zwei Domänenwände in der Mitte im MM von Figur 11a. Das MM in Figur 11c repräsentiert die Umdrehungszahl 3. Der Fehlerzustand (F) der DW-Annihilation wird erkannt.

Figur 11d zeigt die fünfwindige Spirale mit zehn DW. Das MM in Figur 11e repräsentiert die Umdrehungszahl 5. Es ist auch identisch mit dem MM nach DW-Nukleationen, bei der die Spirale komplett mit DW gefüllt wird. Dieser Fehlerzustand (F) wird somit nicht erkannt.

Figur 11e zeigt die fünfwindige Spirale, bei der durch mechanischen Endanschlag nur vier Umdrehungen zählbar sind. Vom regulären Zählbetrieb ist diese fünfte Windung (5) ausgeschlossen und immer DW-frei, um immer DW-Nukleation in dieser Windung detektieren zu können.

Das MM mit zehn DW in Figur 11e ist somit entstanden durch DW-Nukleationen, bei der die Spirale komplett mit DW gefüllt wird. Dieser Fehlerzustand (F) wird erkannt durch die zwei DW in Windung (5), die im regulären Zählbetrieb - Zählung bis zur Umdrehung 4 - nicht existieren.

Figur 11f zeigt eine Variation der fünfwindigen Spirale von Figur 11e, bei der die fünfte Windung breitere Stege hat. Hierdurch nukleieren DW zuerst in der Windung (5). Falls nur zwei DW in dieser Windung nukleieren, kann die Umdrehungszahl noch plausibel ermittelt werden. Das MM in Figur 11f zeigt plausibel die Umdrehungszahl 2 und den Fehlerzustand der DW-Nukleation in Windung (5) an.

Figur 11g zeigt eine Variation der fünfwindigen Spirale von Figur 11f, bei der die erste Windung schmalere Stege hat. Hierdurch pinnen DW mit größerer Wahrscheinlichkeit in der Windung (0) als in den anderen Windungen. Durch mechanischen Endanschlag ist diese Windung vom regulären Zählbetrieb ausgeschlossen und immer mit zwei DW gefüllt, um immer den möglichen Fehlerzustand DW-Pinning mit nachfolgender DW-Annihilation in Windung (0) zu detektieren. Das MM in Figur 11h repräsentiert die Umdrehungszahl 1.

Figur 11h zeigt das MM von Figur 11g, nachdem in der Windung (0) zwei DW annihilierten. Dieser Fehlerzustand (F) wird erkannt. Das MM in Figur 11g repräsentiert plausibel die Umdrehungszahl 1 und zeigt zugleich den Fehlerzustand DW-Annihilation (F) in Windung (0) an.

Während alle erfindungswesentlichen Baugruppen innerhalb des in Fig. 1 rahmenartig umfassten und mit 1a bezeichneten eigentlichen Umdrehungszählers vorgesehen sind, sollen nachstehende Figuren das breite Einsatzfeld der erfindungsgemäßen Lösung verdeutlichen.

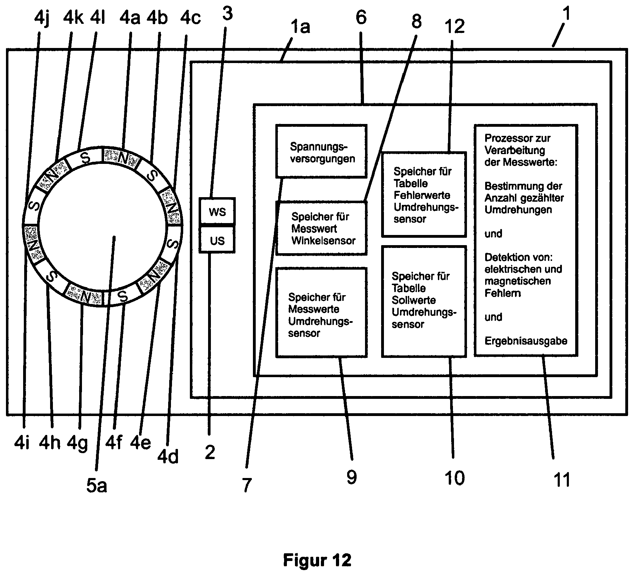

So zeigt Figur 12 den Umdrehungszähler 1a aus Figur 1 kombiniert mit einem Polrad 5a mit Magnetpolen 4a bis 4l anstelle eines Magneten 4 auf einer Welle 5 gemäß Fig. 1. Wenn das Polrad 5a gedreht wird, erzeugt es am Ort des Winkelsensors WS 3 und des Umdrehungssensors US 2 ein magnetisches Drehfeld, dass die Domänenwände des Magnetisierungsmusters im Sensorelement 2 bewegt. Jede Polrad-Position entspricht somit einem Winkelsensor-Messwert und einem Umdrehungszähler-Messwert. Der Umdrehungszähler zählt die Anzahl der vorbei bewegten Magnetpol-Paare. Dies ist analog zum Zählen von Umdrehungen des Magneten 4 gemäß Fig. 1.

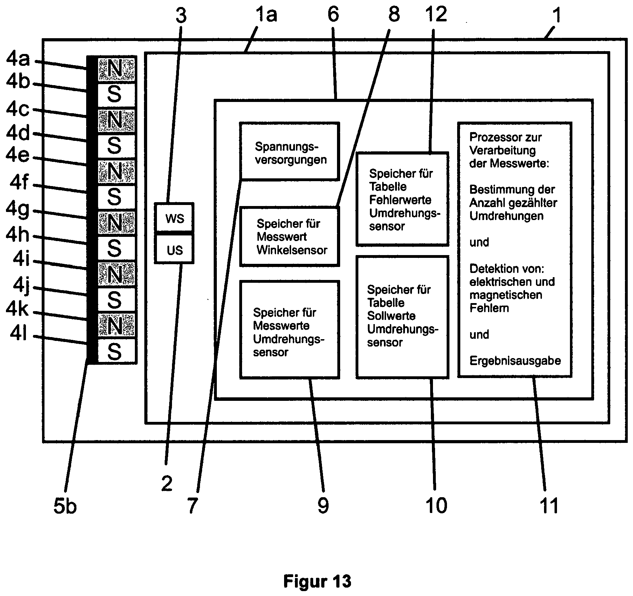

Figur 13 zeigt den Umdrehungszähler 1a aus Fig. 1 kombiniert mit einem Linear-Maßstab 5b mit Magnetpolen 4a bis 4l anstelle eines Magneten 4 auf einer Welle 5 gemäß Fig. 1. Der Linear-Maßstab 5b mit im Beispiel zwölf Magnetpolen (6 Nordpole abwechselnd mit 6 Südpolen) 4a bis 4l repräsentiert auch andere Linear-Massstäbe mit mehr oder weniger Magnetpolen. Wenn der Maßstab 5b relativ zum Umdrehungszähler 1a vorbei bewegt wird, erzeugt er am Ort des Winkelsensors WS 3 und des Umdrehungssensors US 2 ein magnetisches Drehfeld, dass die Domänenwände des eingeprägten Magnetisierungsmusters im Sensorelement 2 bewegt. Jede Maßstab-Position entspricht somit einem Winkelsensor-Messwert und einem Umdrehungszähler-Messwert. Der Umdrehungszähler zählt die Anzahl der vorbei bewegten Magnetpol-Paare. Dies ist analog zum Zählen von Umdrehungen des Magneten 4 gemäß Fig. 1.

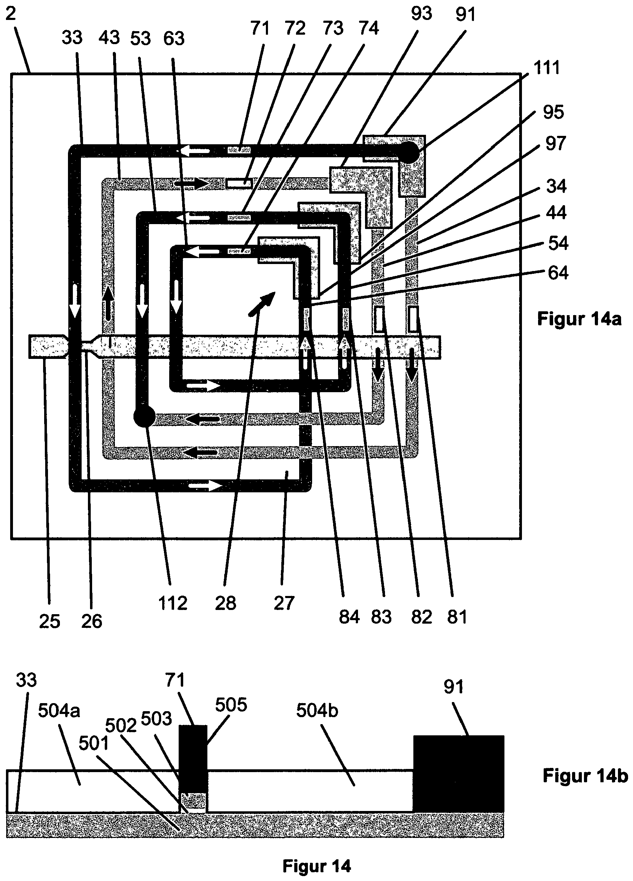

Schließlich zeigen die Figur 14a+b beispielhaft die Auslesung eines Sensorelementes 2 mit TMR-Kontakten mit "360°-Kontaktierung". Die Spirale 27 besteht in diesem Fall aus einem weichmagnetischen Material, z.B. Permalloy.

Figur 14a zeigt eine beispielhafte vierwindige, in sich geschlossene Schleife 27 in Draufsicht. Das Sensorelement 2 wird ausgelesen durch Potentialmessungen mit vier Wheatstone-Halbbrücken WHB1 bis WHB4:

- Die WHB1 besteht aus den Steg 33 mit dem gnd-Tunnelkontakt 71, dem Steg 34 mit dem Vcc-Tunnelkontakt 81 und dem Mittelkontakt 91, der die viertelkreisförmige Ecke zwischen Steg 33 und Steg 34 sowie Teile dieser Stege bedeckt;
- WHB2 besteht aus den Steg 43 mit dem gnd-Tunnelkontakt 72, dem Steg 44 mit dem Vcc-Tunnelkontakt 82 und dem Mittelkontakt 93, der die viertelkreisförmige Ecke zwischen Steg 43 und Steg 44 sowie Teile dieser Stege bedeckt;
- WHB3 besteht aus den Steg 53 mit dem gnd-Tunnelkontakt 73, dem Steg 54 mit dem Vcc-Tunnelkontakt 83 und dem Mittelkontakt 95, der die viertelkreisförmige Ecke zwischen Steg 53 und Steg 54 sowie Teile dieser Stege bedeckt;
- WHB4 besteht aus den Steg 63 mit dem gnd-Tunnelkontakt 74, dem Steg 64 mit dem Vcc-Tunnelkontakt 84 und dem Mittelkontakt 97, der die viertelkreisförmige Ecke zwischen Steg 63 und Steg 64 sowie Teile dieser Stege bedeckt.

Figur 14b zeigt beispielhaft den Steg 33 in einem seitlichen Schnitt durch Fig. 14a stellvertretend für alle Stege mit Tunnelkontakt. Der Steg 33 besteht aus einem weichmagnetischen Material Permalloy 501, geschützt mit einer Oxidschicht 504a und 504b. In Stegmitte ist der gnd-Tunnelkontakt 71 positioniert. Der Tunnelkontakt besteht aus der Permalloylage 501, der Tunnelbarriere 502 (z.B. $Al_2O_3$ oder MgO), einem hartmagnetischen Schichtstapel 503, in die die Referenzrichtung (28 in Figur 14a) eingeschrieben ist, und aus der Goldelektrode 505. Rechts auf dem Steg 33 befindet sich direkt auf dem Permalloy 501 der Mittelkontakt 91 aus Gold. Der Stromfluß beim Tunnelkontakt erfolgt von der Elektrode 505 durch den hartmagnetischen Schichtstapel und durch die Barriere 502 in das Permalloy 501. Typische TMR-Kontakte erreichen Widerstandsänderungen von >100% zwischen paralleler und antiparalleler Magnetisierung der weichmagnetischen und der hartmagnetischen Lage im TMR-Kontakt, d.h. in Abhängigkeit von der jeweiligen Position der Domänenwände 111, 112. Die Initialisierung des erfindungsgemäßen Domänenwandmusters als auch die Auswertung und Bestimmung der aktuellen Umdrehungszahl erfolgt in diesem Beispiel analog zu den zu den Figuren 5ff. bereits beschriebenen Maßgabe und bedarf hier deshalb keiner Wiederholung.

Figur 15 zeigt den Umdrehungssensor von Figur 14a mit einer abgewandelten Kontaktierung, bei der die Widerstände ausgelesen werden. Elektrisch kontaktiert wird diese Schleife mit den gnd-Kontakten 71, 72, 73 und 74 und den Vcc-Kontakten 81, 82, 83 und 84, jeweils ein gnd und ein Vcc-Kontakt auf einer Windung. Damit der TMR-Effekt genutzt wird, müssen z.B. die Vcc-Kontakte jeweils die weichmagnetische Lage und die gnd-Kontakte jeweils die hartmagnetische Lage kontaktieren (analog zur Figur 14b, bei der der Mittelkontakt 91 die weichmagnetische Lage 501 und der gnd-Tunnelkontakt 71 die hartmagnetische Lage kontaktiert), oder umgekehrt. Die Kontakte können abweichend zur Figur 14 anstatt über den Ecken auf den Stegen positioniert sein, vorzugsweise auf gegenüberliegenden Stegen. Zum Beispiel die Vcc-Kontakte 81, 82, 83 und 84 auf den Stegen 31, 41, 51 und 61 und die gnd-Kontakte 71, 72, 73 und 74 auf den Stegen 33, 43, 53 und 63.

Der Magnetisierungszustand des Sensorelementes wird hier durch Widerstandsmessung jeder einzelnen Windung ausgelesen:

Die äußere, erste Windung W1 bilden die Stege 31, 32, 33 und 34 mit dem gnd-Kontakt 71 und dem Vcc-Kontakt 81;
Die zweite Windung W2 bilden die Stege 41, 42, 43 und 44 mit dem gnd-Kontakt 72 und dem Vcc-Kontakt 82;
Die dritte Windung W3 bilden die Stege 51, 52, 53 und 54 mit dem gnd-Kontakt 73 und dem Vcc-Kontakt 83;
Die vierte, innerste Windung W4 bilden die Stege 61, 62, 63 und 64 mit dem gnd-Kontakt 74 und dem Vcc-Kontakt 83;
Auch in diesem Beispiel beträgt der Abstand zwischen den zwei benachbarten Domänenwänden DW 111 und DW 112 540° in cw-Richtung betrachtet.

Alle vorstehend beschriebenen speziellen Ausführungsformen verdeutlichen die Mulivalenz vorliegender Erfindung, die sich sowohl auf bereits bekannte Umdrehungssensoren der gattungsgemäßen Art als auch auf hier neu vorgeschlagene anwenden lässt.

Alle in der Beschreibung, den Ausführungsbeispielen und/oder den nachfolgenden Zeichnungen erkenntlichen Merkmale können einzeln als auch in beliebiger Kombination miteinander erfindungswesentlich sein.

Bezugszeichenliste

| | |
|---|---|
| 1 | Umdrehungszähler-System |
| 1a | Umdrehungszähler |
| 2 | Umdrehungssensor US |
| 3 | Winkelsensor WS |
| 4 | Magnetsystem |
| | 4a, 4c, 4e 4g, 4i 4k Nordpole |
| | 4b, 4d, 4f, 4h, 4j, 4l Südpole |
| 5 | drehende Welle |
| 5a | Polrad |
| 5b | Linear-Maßstab |
| 6 | Elektronik |
| 7 | Spannungsversorgungen |
| 8 | Speicher für die Messwerte des Winkelsensors |
| 8a | Messwert W8 vom Winkelsensor |
| 9 | Speicher für die Messwerte des Umdrehungssensors |
| 9a | Tabelle T9 mit Messwerten vom Umdrehungssensor |
| 10 | Speicher für tabellenartig abgespeicherte Sollwerte des Umdrehungssensors |

| | |
|---|---|
| 10a-10d | Subtabellen mit Sollwerten für den 1. bis 4. Feldwinkel-Quadranten |
| 11 | Verarbeitungseinheit |
| 12 | Speicher für tabellenartig abgespeicherte Sollwert-Fehler-SPF |
| 12a-12d | Subtabellen mit Sollwert-Fehler-SPF für den 1. bis 4. Feldwinkel-Quadranten |
| 20 | Spirale |
| 21, 22 | angespitzte Enden einer Spirale |
| 25 | Leiterbahn zum Initialisieren eines Magnetisierungsmusters |
| 26 | Verengung in Leiterbahn 25 |
| 27 | mehrfach verwundene, in sich geschlossene Schleife |
| 28 | Richtung der Referenzmagnetisierung |
| 31, 32, 33, 34 | Stege der äußersten, ersten Windung |
| 35, 36, 37, 38 | DW-Lagen in der äußersten, ersten Windung |
| 41, 42, 43, 44 | Stege der zweiten Windung |
| 45, 46, 47, 48 | DW-Lagen in der zweiten Windung |
| 51, 52, 53, 54 | Stege der dritten Windung |
| 55, 56, 57, 58 | DW-Lagen in der dritten Windung |
| 63, 64 | Stege er vierten Windung |
| 65 | DW-Lage in der vierten Windung |
| 70, 71, 72, 73, 74 | gnd-Kontakte |
| 80, 81, 82, 83, 84 | Vcc-Kontakte |
| 91, 93, 95, 97, 99 | Mittelkontakte der unterschiedlichen Windungen |
| 111-116 | Domänenwände (DW) |
| 221, 222 | DW-Lücken |
| | |
| 301 | gezoomte Ecke zwischen Steg 51 und Steg 44 |
| 302 | viertelkreis-ähnlicher Polygonzug |
| | |
| 400 | Ablaufdiagramm |
| | |
| 501 | weichmagnetische Schicht |
| 502 | Tunnelbarriere |
| 503 | hartmagnetischer Schichtstapel |
| 504a | Isolationsschicht |
| 504b | Isolationsschicht |
| 505 | Goldelektrode auf Tunnelkontakt |

## Patentansprüche

1. Magnetischer Umdrehungszähler respektive Verschiebungszähler zur Selbsterkennung von Fehlerzuständen bei der Bestimmung von mit diesem Umdrehungszähler respektive Verschiebungszähler vorgebbar ermittelbaren Umdrehungszahlen respektive Verschiebungszahlen n, erzeugt durch ein rotierendes magnetisches Element (4), respektive Verschiebungszahlen erzeugt durch eine vorbei bewegbare Anzahl n an Magnetpolen eines rotierenden Polrades (5a), respektive eines vorbei bewegbaren linearen magnetischen Maßstabes (5b), beinhaltend einen Sensor (2), der magnetische Domänenwandleitbahnen beinhaltet, die aus offenen Spiralen (20; 20a, 20b) oder in sich geschlossenen mehrfach verwundenen Schleifen (27) bestehen, die durch einen GMR-Schichtstapel oder eine weichmagnetische Schicht mit lokal vorhandenen TMR-Schichtstapeln gebildet sind und in die magnetische 180°-Domänenwände einbringbar sind und deren Anwesenheit oder Fehlen durch Messung des elektrischen Widerstands vorgebbarer Spiralen- oder Schleifenabschnitte, vermittels auf den Domänenwandleitbahnen vorgesehener Kontakte (70, 80; 91, 93 95, 90, 92, 94 oder 70, 80; 91, 93, 95, 97 oder 71, 81; 91, 93, 95, 97-72, 82; 99, 101, 103, 105, 107 oder 71, 81; 91, 93-72, 82; 95, 97, 99 oder 71, 81; 91 bis 74, 84; 95) bestimmbar ist, wobei

- ein erster Speicher (9), ein zweiter Speicher (10) und eine Verarbeitungseinheit (11) vorgesehen sind,
- in die Domänenwandleitbahnen ein vorgebbares eineindeutiges Magnetisierungsmuster (MM) von Domänenwänden (DW) und/oder Domänenwandlücken (DWL) eingeschrieben ist,
- genannte Kontakte nebst zugehöriger, von ihnen erfasster Domänenwandleitbahnabschnitten zu separaten aber gemeinsam auslesbaren Wheatstonebrücken, respektive - halbbrücken, verschaltet sind, wobei die von den Wheatstonebrücken, respektive -halbbrücken, ermittelten Widerstandsverhältnisse als Signalpegel in Form von Signalpegelfolgen (SPF) sämtlich in dem ersten Speicher (9) tabellenartig ablegbar sind, wobei die im ersten Speicher (9) abgelegten Signalpegelfolgen (SPF) zur Ermittlung der aktuellen Umdrehungs- oder Verschiebungszahl fortlaufend mit in dem zweiten Speicher (10) abgelegten tabellenartigen Sollwertmustern (10a, 10b, 10c und 10d) der Signalpegelfolgen für jede zulässige Umdrehung i ($0 \leq i \leq n$) vergleichbar ist und

- ein dritter Speicher (12) vorgesehen ist, in dem tabellenartige Fehler-Sollwertmuster (12a, 12b, 12c, 12d) für alle möglichen unbeabsichtigten Änderungen im eingeschriebenen Magnetisierungsmuster (MM) und den dadurch hervorgerufenen Abweichungen von Signalpegelfolgen (SPF) vom im zweiten Speicher (10) abgelegten regulären Signalpegelfolgen abgelegt sind, die aber noch eindeutig einer Umdrehungszahl oder einem Verschiebungsschritt zuordenbar sind und

- vermittels der Verarbeitungseinheit (11) ein fortlaufender Vergleich zwischen den im ersten Speicher (9) abgelegten ermittelten Signalpegelfolgen mit denen von in dem zweiten Speicher (10) und dem dritten Speicher (12) abgelegten Signalpegelfolgen vornehmbar ist und

- bereits während einer ganzen oder halben Umdrehung des rotierenden Elements (4) oder eines Verschiebungsschrittes des rotierenden Polrades (5a), respektive des vorbei bewegbaren linearen magnetischen Maßstabes (5b) der Signalpegel als eineindeutiger Umdrehungs- oder Verschiebungswert oder sofort als nicht korrigierbarer Fehler ausgebbar ist.

2. Magnetischer Umdrehungszähler nach Anspruch 1, **dadurch gekennzeichnet, dass** neben dem Umdrehungszähler (2) ein weiterer Winkel- oder Quadrantensensor (3) zur Detektion der Winkellagen des rotierenden Elements (4), respektive Polrads (5a) oder linearen Verschiebungen des linearen Maßstabes (5b), vorgesehen ist, dessen Signal vorgibt, welche der den Quadranten, respektive Winkel- oder linearen Maßstababschnitten zugeordneten Subtabellen (10a -10d) im zweiten Speicher (10) und Subtabellen (12a - 12d) im dritten Speicher (12) zum Vergleich vermittels der Verarbeitungseinheit (11) hinzuzuziehen sind.

3. Magnetischer Umdrehungszähler nach Anspruch 1, **dadurch gekennzeichnet, dass** die Domänenwandleitbahn aus einer mehrwindigen Spirale (20) gebildet ist, die beidseits in zwei spitze Enden (21, 22) ausläuft oder an Stelle der Spitzen ein oder je ein Domänenwandgenerator (23, 24) vorgesehen ist, wobei in diese, im Wesentlichen rautenförmig ausgeführte Spirale (20), ein definiertes Magnetisierungsmuster (MM) mit einem vorgebaren Abstand zwischen zwei benachbarten Domänenwänden (DW) oder Domänenwandlücken (DWL) eingeprägt ist und auf den Domänenwandleitbahnen elektrische Kontakte derart vorgesehen sind, dass die Domänenwandleitbahnen diagonal gegenüber liegend von je einem gnd- (70) und einem Vcc-Kontakt (80) gemeinsam, bzw. in Vcc-Kontakt-Gruppen und gnd-Kontakt-Gruppen bei Multiplex-Auslesung, erfasst sind und ausschließlich einseitig und im Wesentlichen mittig zwischen genanntem gnd-(70) und Vcc-Kontakt (80) separate Kontakte (91, 93, 95 und 90, 92, 94) auf jedem einzelnen Domänenwandleitbahnabschnitt vorgesehen sind, bzw. bei Multiplex-Auslesung in Gruppen von Kontakten, die mehrere Windungen als Wheatstone-(Halbbrücken)-Mittelkontakt kontaktieren.

4. Magnetischer Umdrehungszähler nach Anspruch 1, **dadurch gekennzeichnet, dass** die Domänenwandleitbahn aus einer mehrwindigen in sich geschlossenen und im Wesentlichen rautenförmig ausgeführten Spirale (27) gebildet ist, in die mindestens zwei magnetische Domänenwände derart eingebracht sind, dass die mindestens zwei Domänenwände (111, 112) durch Mittel (25, 26) zum Erzeugen, Pinnen oder definierten Löschen von Domänenwänden in einen definierten Abstand von größer als 360° zueinander -bezogen auf ihre Ortsveränderung von erster zu zweiter Position, bei Drehung des äußeren Magnetfeldes um den Winkel von größer als 360°- gebracht und so zueinander beabstandet sind, wobei auf den Domänenwandleitbahnen elektrische Kontakte derart vorgesehen sind, dass die Domänenwandleitbahnen diagonal gegenüber liegend von je einem gnd-Kontakt und von je einem Vcc-Kontakt pro Windung, bzw. bei Multiplex-Auslesung von je einem gemeinsamen gnd-Kontakt (70) und einem Vcc-Kontakt (80) und zwischen genannten Kontakten (70, 80) einseitig angeordneten Mittelkontakten (91, 93, 95 und 97) auf jedem Schleifenabschnitt erfasst sind.

5. Magnetischer Umdrehungszähler nach Anspruch 1 oder 3, **dadurch gekennzeichnet, dass** die Domänenwandleitbahn aus zwei nebeneinander angeordneten mehrwindigen im Wesentlichen rautenförmig ausgeführten Teilspiralen (20a, 20b) mit gleichem Windungsdrehsinn gebildet ist, wobei jede der Teilspiralen (20a, 20b) gegenüber liegend von je einem gemeinsamen gnd-Kontakt (71; 72) und Vcc-Kontakt (81; 82) erfasst sind und einseitige zwischen genannten gnd- und Vcc-Kontakten Mittelkontakte (91, 93, 95, 97; 99, 101, 103, 105, 107) vorgesehen sind und in die Domänenwandleitbahn ein definiertes Magnetisierungsmuster von Domänenwänden, durch Mittel (25, 26) zum Erzeugen, Pinnen oder definierten Löschen von Domänenwänden in einen definierten Abstand von größer als 360° zueinander -bezogen auf ihre Ortsveränderung von erster zu zweiter Position, bei Drehung des äußeren Magnetfeldes um den Winkel von größer als 360°-gebracht und diese benachbarten Domänenwände so zueinander beabstandet sind, eingeschrieben ist.

6. Magnetischer Umdrehungszähler nach einem der vorstehenden Ansprüche, **dadurch gekennzeichnet, dass** alle Domänenwandleitbahnen als zueinander parallel verlaufende und über genannte Kontakte gemeinsam auslesbare Domänenwandleitbahnen ausgeführt sind, die jeweils zum Zeitpunkt der Initialisierung mit identischen Magnetisierungsmustern versehen sind.

7. Magnetischer Umdrehungszähler nach Anspruch 1 und 4, **dadurch gekennzeichnet, dass** mehrere, von einander separierte und in sich geschlossene mehrfach verwundenen Schleifen (S5, S8, S9) vorgesehen sind, deren jeweils maximal eineindeutig bestimmbare Umdrehungszahl, bei vorgebbarer Domänenwandbesetzung, untereinander teilerfremd festgelegt ist.

**Claims**

1. A magnetic revolution counter or displacement counter for the self-detection of error states in the determination of revolution numbers or displacement numbers n ascertainable in a predefinable manner by way of this revolution counter or displacement counter, generated by a rotating magnetic element (4), or displacement number, generated by a number n of magnetic poles of a rotating magnet wheel (5a) that can be moved past, or by a linear magnetic scale (5b) that can be moved past, comprising a sensor (2), which includes magnetic domain wall conductors composed of open spirals (20; 20a, 20b) or closed, multiply-wound loops (27), which are formed by a GMR layer stack or a soft magnetic layer comprising locally present TMR layer stacks and in which magnetic 180° domain walls can be introduced, and the presence or absence thereof can be determined by measuring the electrical resistance of predefinable spiral or loop sections, by way of contacts (70, 80; 91, 93 95, 90, 92, 94 or 70, 80; 91, 93, 95, 97 or 71, 81; 91, 93, 95, 97-72, 82; 99, 101, 103, 105, 107 or 71, 81; 91, 93-72, 82; 95, 97, 99 or 71, 81; 91 to 74, 84; 95) provided on the domain wall conductors, wherein

   - a first memory (9), a second memory (10) and a processing unit (11) are provided,
   - a predefinable bijective magnetization pattern (MP) of domain walls (DW) and/or domain wall gaps (DWG) is written into the domain wall conductors,
   - said contacts, together with associated domain wall conductor sections captured thereby, are interconnected to form Wheatstone bridges or half bridges that are separate, but can be read out together, wherein the resistance ratios ascertained by the Wheatstone bridges or half bridges are all stored as signal levels in the form of signal level sequences (SLS) in the first memory (9) in tabular form, wherein the signal level sequences (SLS) stored in the first memory (9) can be continuously compared to tabular target value patterns (10a, 10b, 10c and 10d) of the signal level sequences stored in the second memory (10) for each permissible revolution i ($0 \leq i \leq n$) for the ascertainment of the present revolution number or displacement number, and
   - a third memory (12) is provided, in which tabular error target value patterns (12a, 12b, 12c, 12d) for all possible, not intended changes in the written-in magnetization pattern (MP) and the deviations of signal level sequences (SLS), caused thereby, from regular signal level sequences stored in the second memory (10) are stored, which, however, can still be bijectively assigned to a revolution number or a shift step, and
   - a continuous comparison can be carried out by way of the processing unit (11) between the ascertained signal level sequences stored in the first memory (9) and the signal level sequences stored in the second memory (10) and the third memory (12), and
   - the signal level can be output during an entire or a half revolution of the rotating element (4), or a shift step of the rotating magnet wheel (5a), or of the linear magnetic scale (5b) that can be moved past, as a bijective revolution value or shift value, or directly as an uncorrectable error.

2. The magnetic revolution counter according to claim 1, **characterized in that**, in addition to the revolution counter (2), a further angle sensor or quadrant sensor (3) is provided for detecting the angular positions of the rotating element (4), or of the magnet wheel (5a), or of linear displacements of the linear scale (5b), the signal of the sensor specifying which of the sub-tables (10a-10d) assigned to the quadrants, or angle sections, or linear scale sections, in the second memory (10), and sub-tables (12a-12d) in the third memory (12) are to be used for the comparison by way of the processing unit (11).

3. The magnetic revolution counter according to claim 1, **characterized in that** the domain wall conductor is formed of a multi-turn spiral (20), which ends in two pointed ends (21, 22) at both ends, or instead of the tips one or a respective domain wall generator (23, 24) is provided, wherein a defined magnetization pattern (MP) having a predefinable separation between two neighbouring domain walls (DW) or domain wall gaps (DWG) is impressed into this substantially rhombus-shaped spiral (20), and electrical contacts are provided on the domain wall conductors such that the domain wall conductors, located diagonally opposed, are captured by a respective GND contact (70) and VCC contact (80) collectively, or in VCC contact groups and GND contact groups with a multiplex read-out, and separate contacts (91, 93, 95, and 90, 92, 94) are provided on each individual domain wall conductor section solely on one side and substantially centred between the aforementioned GND contact (70) and VCC contact (80), or, with a multiplex read-out, in groups of contacts that contact a plurality of windings as a Wheatstone (half bridge) centre contact.

4.  The magnetic revolution counter according to claim 1, **characterized in that** the domain wall conductor is formed of a multi-turn, closed and substantially rhombus-shaped spiral (27), into which at least two magnetic domain walls are introduced such that the at least two domain walls (111, 112) by way of means (25, 26) for generating, pinning or deleting domain walls, in a defined manner, are brought into a defined separation of greater than 360° with respect to one another, based on the change in location thereof from a first to a second position, with a rotation of the outer magnetic field by the angle of greater than 360°, and are thus spaced apart from one another, wherein electrical contacts are provided on the domain wall conductors such that the domain wall conductors, located diagonally opposed, are captured by a respective GND contact and by a respective VCC contact per winding or, with a multiplex read-out, by a shared GND contact (70) and a VCC contact (80) and centre contacts (91, 93, 95, and 97) disposed on one side between the aforementioned contacts (70, 80), on each loop section.

5.  The magnetic revolution counter according to claim 1 or 3, **characterized in that** the domain wall conductor is formed of two juxtaposed multi-turn, substantially rhombus-shaped sub-spirals (20a, 20b) having the same winding direction of rotation, wherein each of the sub-spirals (20a, 20b), located opposite one another, are captured by a respective shared GND contact (71; 72) and VCC contact (81; 82), and centre contacts (91, 93, 95, 97; 99, 101, 103, 105, 107) are provided on one side between the aforementioned GND and VCC contacts, and a defined magnetization pattern of domain walls is written into the domain wall conductor, which by way of means (25, 26) for generating, pinning or deleting domain walls, in a defined manner, are brought into a defined separation of greater than 360° with respect to one another, based on the change in location thereof from a first to a second position, with a rotation of the outer magnetic field by the angle of greater than 360°, and these adjoining domain walls are thus spaced apart from one another.

6.  A magnetic revolution counter according to any one of the preceding claims, **characterized in that** all domain wall conductors are designed as domain wall conductors that extend parallel to one another and can be jointly read out via the aforementioned contacts and that are provided with identical magnetization patterns at the respective point of time of the initialization.

7.  A magnetic revolution counter according to claims 1 and 4, **characterized in that** a plurality of mutually separated and closed, multiply-wound loops (S5, S8, S9) are provided, the respective maximally bijectively determinable revolution number, with a predefinable domain wall occupancy, being established in a coprime manner among one another.

**Revendications**

1.  Compte-tours magnétique ou compteur de décalages destiné à l'autodétection d'états de défaut lors de la détermination de nombres de révolutions ou de nombres de décalages n prédéfinissables aptes à être déterminés par ce compte-tours ou compteur de décalages, générés par un élément magnétique rotatif (4), ou nombres de décalages, générés par passage d'un nombre n de pôles magnétiques d'une roue polaire (5a) rotative ou par passage d'une échelle linéaire (5b) magnétique, comprenant un capteur (2) comprenant des pistes conductrices magnétiques de parois de domaine, lesquelles consistent en spirales (20; 20a, 20b) ouvertes ou en boucles (27) fermées à plusieurs enroulements, lesquelles sont formées par un empilement de couches GMR ou par une couche magnétique douce à empilements TMR locaux et dans lesquelles peuvent être intégrées des parois de domaines 180° magnétiques dont la présence ou l'absence peut être déterminée en mesurant la résistance électrique de secteurs prédéfinissables des spirales ou des boucles au moyen de contacts (70, 80; 91, 93, 95, 90, 92, 94 ou 70, 80; 91, 93, 95, 97 ou 71, 81; 91, 93, 95, 97-72, 82; 99, 101, 103, 105, 107 ou 81; 91, 93-72, 82; 95, 97, 99 ou 71, 81; 91 à 74, 84; 95) prévus sur les pistes conductrices des parois de domaine, dans lequel

   - une première mémoire (9), une deuxième mémoire (10) et une unité de traitement (11) sont prévues,
   - un motif d'aimantation (MA) bi-univoque prédéfinissable de parois de domaine (PD) et/ou d'interstices entre parois de domaine (IPD) est inscrit dans les pistes conductrices des parois de domaine,

- lesdits contacts et les secteurs des pistes conductrices des parois de domaine associées saisies par ceux-ci sont connectés en ponts ou demi-ponts de Wheatstone séparés, mais lisibles en commun, les rapports de résistances déterminés par les ponts ou demi-ponts Wheatstone pouvant être tous enregistrés sous forme tabulaire dans la première mémoire (9) en tant que niveaux de signal sous forme de séries de niveaux de signal (SNS), les séries de niveaux de signal (SNS) enregistrées dans la première mémoire (9) pouvant être comparées continuellement pour chaque tour valide i ($0 \leq i \leq n$) avec les schémas des valeurs de consigne (10a, 10b, 10c et 10d) des séries de niveaux de signal déposés dans la deuxième mémoire (10) et

- une troisième mémoire (12) est prévue, dans laquelle sont déposés des schémas de défaut des valeurs de consigne (12a, 12b, 12c, 12d) pour toutes les modifications involontaires possibles dans le motif d'aimantation (MA) inscrit et les déviations de séries de niveaux de signal (SNS) qui en résultent par rapport à des séries de niveaux de signal régulières déposées dans la deuxième mémoire (10), mais qui peuvent être attribuées univoquement à un nombre de tours ou à un pas de décalage et

- au moyen de l'unité de traitement (11), une comparaison continuelle entre les séries de niveaux de signal déterminées et déposées dans la première mémoire (9) et les séries de niveaux de signal déposées dans la deuxième mémoire (10) et la troisième mémoire (12) peut être effectuée et

- dès un tour complet ou un demi-tour de l'élément rotatif (4) ou lors d'un pas de décalage de la roue polaire (5a) rotative ou par passage de l'échelle linéaire magnétique (5b), le niveau de signal peut être émis en tant que valeur de révolution ou de décalage bi-univoque ou immédiatement en tant qu'erreur incorrigible.

2. Compte-tours magnétique selon la revendication 1, **caractérisé en ce que**, outre le compte-tours (2), un autre capteur d'angle ou de quadrant (3) est prévu pour la détection des positions angulaires des éléments rotatifs (4), ou de la roue polaire (5a) ou des décalages de l'échelle linéaire (5b), le signal duquel spécifie lesquelles des sous-tables (10a-10d) dans la deuxième mémoire (10) et des sous-tables (12a-12d) dans la troisième mémoire (12) associées aux quadrants ou aux secteurs des angles ou de l'échelle linéaire sont à consulter pour la comparaison par l'unité de traitement (11).

3. Compte-tours magnétique selon la revendication 1, **caractérisé en ce que** la piste conductrice d'une paroi de domaine est formée d'une spirale (20) à plusieurs enroulements qui se termine par deux extrémités (21, 22) pointues ou que, en lieu et place des pointes, est prévu un générateur de paroi de domaine (23, 24), ou un pour chacune, cette spirale (20), adoptant sensiblement la forme d'un losange étant empreinte d'un motif d'aimantation (MA) défini d'un écart définissable entre deux parois de domaine (PD) ou interstices entre parois de domaine (IPD) adjacents et des contacts électriques étant prévus sur les pistes conductrices des parois de domaine de manière à ce que les pistes conductrices des parois de domaine soient saisies en commun et en positions diagonalement opposées, chacune par un contact gnd (70) et un contact Vcc (80), ou, lors d'une lecture multiplexée, par les groupes de contacts Vcc et des groupes de contacts gnd, et des contacts séparés (91, 93, 95 et 90, 92, 94) étant prévus sur chaque secteur des pistes conductrices des parois de domaines uniquement d'un côté et sensiblement centrés entre ledit contact gnd (79) et ledit contact (80) ou, lors d'une lecture multiplexée, des groupes de contacts qui contactent plusieurs enroulements en tant que contact central du (demi-pont) Wheatstone.

4. Compte-tours magnétique selon la revendication 1, **caractérisé en ce que** la piste conductrice de la paroi de domaine est formée d'une spirale (27) fermée à plusieurs enroulements et sensiblement en forme de losange, dans laquelle sont introduites au moins deux parois de domaine magnétiques de manière à ce que les au moins deux parois de domaine (111, 112), par des moyens (25, 26) pour la génération, l'ancrage ou l'effacement défini de parois de domaines, soient amenées à un écart défini supérieur à 360° l'une par rapport à l'autre relativement à leur déplacement de la première à la deuxième position lors de la rotation du champ magnétique externe autour d'un angle supérieur à 360° et soient ainsi espacées l'une par rapport à autre, des contacts électriques étant prévus sur les parois de domaine de manière à ce que les pistes conductrices des parois de domaine soient saisies en positions diagonalement opposées, chacune par un contact gnd et chacune par un contact Vcc par enroulement ou, lors d'une lecture multiplexée, chacune par un contact gnd (70) et un contact Vcc (80) communs et des contacts centraux (91, 93, 95 et 97) positionnés d'un côté entre lesdits contacts (70, 80), sur chaque secteur de la boucle.

5. Compte-tours magnétique selon la revendication 1 ou 3, **caractérisé en ce que** la piste conductrice de la paroi de domaine est formée par deux sous-spirales (20a, 20b) à plusieurs enroulements dans le même sens et adoptant sensiblement la forme d'un losange, juxtaposées, chacune des sous-spirales (20a, 20b) étant saisie, en positions opposées, par un contact gnd (71; 72) et un contact Vcc (81; 82) communs, des contacts centraux (91, 93, 95, 97; 99, 101, 103, 105, 107) étant prévus d'un côté entre lesdits contacts gnd et Vcc, et un motif d'aimantation (MA) défini de parois de domaines étant inscrit dans la piste conductrice des parois de domaines par des moyens (25, 26) de génération, d'ancrage ou l'effacement défini de parois de domaine à un écart défini supérieur à 360° l'une par rapport à l'autre relativement à leur déplacement de la première à la deuxième position lors de la rotation du champ magnétique externe autour d'un angle supérieur à 360° et ces parois de domaine adjacentes se trouvant ainsi espacées l'une par rapport à autre.

6. Compte-tours magnétique selon l'une des revendications précédentes, **caractérisé en ce que** toutes les pistes conductrices sont réalisées en tant que pistes conductrices de parois de domaine parallèles les unes aux autres et lisibles en commun par lesdits contacts et qui sont pourvues de motifs d'aimantation identiques au moment de leur initialisation.

7. Compte-tours magnétique selon la revendication 1 ou 4, **caractérisé en ce que** plusieurs boucles (S5, S8, S9) fermées à plusieurs enroulements, séparées les unes des autres, sont prévues, dont le nombre de tours maximalement déterminable de manière bi-univoque est défini comme étant copremiers les uns par rapport aux autres pour une occupation des parois de domaine prédéfinissable.

**Figur 1**

400

1a 2 1 5 4 3 6 7 8 8a 9 9a 10 10a 10b 10c 10d 12 12a 12b 12c 12d 11

Start Messzyklus

Elektronik 6 liest WS-Sensor 3 und US-Sensor 2 aus und speichert die Messwerte im Speicher 8 und Speicher 9

Verarbeitungseinheit 11 bestimmt Feldwinkel-Quadrant Q1, Q2, Q3 oder Q4

Verarbeitungseinheit 11 liest Sollwert-SPF aus Speicher 10 ein (z.B. für Q1)

Verarbeitungseinheit 11 setzt Laufindex i auf null : i = 0

i von 0 bis n

Vergleich Sollwert-SPF(i) : Messwert-SPF richtig ? — ja

nein

Laufindex i wird erhöht : i = i+1

i+1 > n ? — ja

nein

Verarbeitungseinheit 11 setzt Laufindex i auf null : i = 0

i von 0 bis n

Verarbeitungseinheit 11 liest m(i) Sollwert-Fehler-SPF aus Speicher 12 ein (z.B. für Q1) (m > 0)

Verarbeitungseinheit 11 setzt Laufindex j auf null : j = 0

j von 0 bis m

Vergleich Soll-wert-Fehler-SPF(j(i)) : Messwert-SPF richtig ? — ja

nein

Laufindexerhöhung : j = j+1

j+1 > m ? — ja

nein

i+1 > n ? — ja

nein

Laufindexerhöhung : i = i+1

Verarbeitungs-einheit 11 gibt Umdrehungs-zahl i aus

Verarbeitungs-einheit 11 gibt Fehlerwert aus

Verarbeitungs-einheit 11 gibt Fehlerwert und Umdrehungs-zahl i aus

Ende Messzyklus

Welle

Welle

S N

US WS

Spannungs-versorgungen

Speicher für WS-Messwert — W8

Speicher für US-Messwerte — T9

Speicher für Sollwert-SPF

S1 Q1 | S2 Q2 | S3 Q3 | S4 Q4

Speicher für Sollwert-Fehler-SPF

SF1 Q1 | SF2 Q2 | SF3 Q3 | SF4 Q4

Prozessor zur Verarbeit-ung der Messwerte: Umdrehungszahl-Bestimmung, Fehlerverarbeitung und Ergebnisausgabe

**Figur 2**

Figur 3a

Figur 3b

Figur 3c

Figur 3d

0    Figur 3e

1    Figur 3f

2    Figur 3g

3    Figur 3h

4    Figur 3i

0    Figur 3j

1    Figur 3k

2    Figur 3l

**Figur 3**

Figur 4a

Figur 4b

Quadrant: 1 2 3 4 1 2 3 4

Figur 4c

Figur 4d

Figur 4e

Figur 4f

Figur 4g

Figur 4h

Figur 4i

Figur 4j

Figur 4k

**Figur 4**

**Figur 5**

**Figur 6**

**Figur 7**

**Figur 8**

**Figur 9**

**Figur 10a**

S5 ......................... 0U

2   3   4   0(n*5) 1   2

S8 ......................... 2U

5   6   7   0(n*8) 1   2   3   4   5

S9 ......................... 1U

6   7   8   0(n*9) 1   2   3   4   5   6

S5 + S8 : 0U + 2U --> 10 U
S5 + S9 : 0U + 1U --> 10 U
S8 + S9 : 2U + 1U --> 10 U

**Figur 10b**

S5 ......................... 0U

2   3   4   0(n*5) 1   2

S8 ......................... 2U + F

5   6   7   0(n*8) 1   2   3   4   5

S9 ......................... 1U

6   7   8   0(n*9) 1   2   3   4   5   6

S5 + S8 : 0U + (2U + F) --> 10 U + F
S5 + S9 : 0U + 1U        --> 10 U
S8 + S9 : (2U + F) + 1U --> 10 U + F

**Figur 10**

Figur 11

4j 4k 4l 4a 4b 4c 3 1a 6 8 12 1

| WS |
| US |

Spannungsversorgungen

Speicher für
Messwert
Winkelsensor

Speicher für
Messwerte
Umdrehungssensor

Speicher für
Tabelle
Fehlerwerte
Umdrehungssensor

Speicher für
Tabelle
Sollwerte
Umdrehungssensor

Prozessor zur
Verarbeitung
der Messwerte:

Bestimmung der
Anzahl gezählter
Umdrehungen

und

Detektion von:
elektrischen und
magnetischen
Fehlern

und

Ergebnisausgabe

4i 4h 4g 4f 4e 4d 2

5a 7 9 10 11

**Figur 12**

3  1a  6  8  12  1

4a
4b
4c
4d
4e
4f
4g
4h
4i
4j
4k
4l

| N |
|---|
| S |
| N |
| S |
| N |
| S |
| N |
| S |
| N |
| S |
| N |
| S |

WS

US

Spannungsversorgungen

Speicher für
Messwert
Winkelsensor

Speicher für
Tabelle
Fehlerwerte
Umdrehungssensor

Prozessor zur
Verarbeitung
der Messwerte:

Bestimmung der
Anzahl gezählter
Umdrehungen

und

Detektion von:
elektrischen und
magnetischen
Fehlern

und

Ergebnisausgabe

Speicher für
Messwerte
Umdrehungssensor

Speicher für
Tabelle
Sollwerte
Umdrehungssensor

5b  2  7  9  10  11

**Figur 13**

**Figur 14a**

**Figur 14b**

**Figur 14**

**Figur 15**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008063226 A1
- DE 102010022611 A1
- DE 102011075306 A1
- DE 102013018680 A1

**In der Beschreibung aufgeführte Nicht-Patentliteratur**

- *IEEE Transactions on Magnetics,* 2009, vol. 45 (10), 3792-3795